(19) Europäisches Patentamt
European Patent Office
Office européen des brevets

(11) **EP 1 544 898 A1**

(12) **EUROPEAN PATENT APPLICATION**
published in accordance with Art. 158(3) EPC

(43) Date of publication:
**22.06.2005 Bulletin 2005/25**

(51) Int Cl.7: **H01L 21/02**, H01L 21/31,
H01L 21/68, C23C 16/44,
H05B 3/02

(21) Application number: **03748595.0**

(22) Date of filing: **26.09.2003**

(86) International application number:
**PCT/JP2003/012311**

(87) International publication number:
**WO 2004/030055 (08.04.2004 Gazette 2004/15)**

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(30) Priority: **27.09.2002 JP 2002282120**

(71) Applicant: **SUMITOMO ELECTRIC INDUSTRIES,
Ltd**
**Osaka-shi, Osaka 541-0041 (JP)**

(72) Inventors:
• **Natsuhara, Masuhiro, Itami Works**
**Itami-shi, Hyogo 664-0016 (JP)**
• **Nakata, Hirohiko, Itami Works**
**Itami-shi, Hyogo 664-0016 (JP)**
• **Kuibira, Akira, Itami Works**
**Itami-shi, Hyogo 664-0016 (JP)**
• **Hashikura, Manabu, Itami Works**
**Itami-shi, Hyogo 664-0016 (JP)**

(74) Representative: **Cross, Rupert Edward Blount**
**BOULT WADE TENNANT,**
**Verulam Gardens**
**70 Gray's Inn Road**
**London WC1X 8BT (GB)**

(54) **WAFER HOLDER AND SEMICONDUCTOR MANUFACTURING APPARATUS**

(57)    A wafer holder furnished with a plurality of anchored tubular pieces and/or anchored support pieces affixed to the holder's ceramic susceptor and in which damage to the anchored tubular pieces due to thermal stress during heating operations is prevented, and a high-reliability semiconductor manufacturing apparatus utilizing the wafer holder are made available.

One end of at least two of the anchored tubular pieces (5) and/or anchored support pieces is affixed to the ceramic susceptor (2) and the other end is fixed in the reaction chamber (4), wherein letting the highest temperature the ceramic susceptor (2) attains be $T1$, the thermal expansion coefficient of the ceramic susceptor (2) be $\alpha 1$, the highest temperature the reaction chamber (4) attains be $T2$, the thermal expansion coefficient of the reaction chamber (4) be $\alpha 2$, the longest inter-piece distance on the ceramic susceptor (2) among the plurality of anchored tubular pieces (5) and/or anchored support pieces at normal temperature be $L1$, and the longest inter-piece distance on the reaction chamber (4) among the plurality of anchored tubular pieces (5) and/or anchored support pieces at normal temperature be $L2$, then the relational formula $|(T1 \times \alpha 1 \times L1) - (T2 \times \alpha 2 \times L2)| \leq 0.7$ mm is satisfied.

FIG. 1A

**Description**

Technical Field

The present invention relates to wafer holders employed in semiconductor manufacturing operations such as plasma-assisted CVD, low-pressure CVD, low-*k* film baking, plasma etching and dielectric-film CVD, and to semiconductor manufacturing apparatuses furnished with the wafer holders.

Background Art

A variety of semiconductor manufacturing apparatuses for implementing on semiconductor wafers processes such as film-deposition and etching has been proposed to date. Such semiconductor manufacturing apparatuses are in their reaction chambers provided with wafer holders furnished with a resistive heating element, and carry out various processes on wafers while the wafers are retained and heated on the wafer holders.

A semiconductor wafer-heating device proposed in Japanese Unexamined Pat. App. Pub. No. H04-78138, for example, includes: a heater part made of ceramic, in which a resistive heating element is embedded, and that is provided with a wafer-heating side and is installed within a reaction chamber; a columnar support part provided on the side of the heater part other than its wafer-heating side and that forms a gastight seal between it and the reaction chamber, and electrode elements connected to the resistive heating element and leading out to the reaction chamber exterior so as substantially not to be exposed to the reaction-chamber interior space.

In another example, a structure in which a plurality of tubular pieces is joined to a ceramic susceptor (wafer holder) to support the susceptor is proposed in Japanese Unexamined Pat. App. Pub. No. H05-9740. This structure, which is an improvement on the ceramic wafer-heating device set forth in the abovementioned Pat. App. Pub. No. H04-78138, is one in which at least one of the electrode elements furnished in the ceramic susceptor is surrounded by a tubular piece made from an inert insulating material, and in which one end of the tubular piece is joined airtightly onto the ceramic susceptor, while the other end thereof is inserted through a through-hole provided in the reaction chamber, where it is sealed airtight.

What with a columnar support part attached to the ceramic susceptor in the wafer-heating device set forth in the abovementioned Pat. App. Pub. No. H04-78138, the columnar support part itself in order to support the ceramic susceptor ends up being of relatively large heat capacity, wherein a drawback has been that consequently the amount of heat escaping from the ceramic susceptor is large, spoiling the temperature uniformity of the wafer-heating face.

In the wafer-heating device of the abovementioned Pat. App. Pub. No. H05-9740, the fact that a plurality of tubular pieces is joined fast to the ceramic susceptor has meant that the stress acting on the tubular pieces during heating processes is great, such that the danger has been that in worst-case scenarios the tubular pieces have been destroyed. In particular, when the temperature of the ceramic susceptor has been elevated to a constant level, the distance between the tubular pieces affixed to the susceptor grows larger due to thermal expansion of the susceptor. Meanwhile, with heat from the ceramic susceptor and tubular pieces being transmitted to the reaction chamber, through which the other ends of the tubular pieces are inserted, the chamber also expands. Under these circumstances, in some cases the difference in extent of thermal expansion between the ceramic susceptor and the reaction chamber has been so significant that the stress acting on the tubular pieces grows large enough to damage them.

Especially with the transition to silicon wafers of larger diametric span moving forward in recent years have been calls for uniform heating of 12-inch silicon wafers. Because accompanying this transition has been a scaling-up of the ceramic susceptors that heat the wafers, thermal stress acting on the tubular pieces while the ceramic susceptors are heating has grown greater, which has made damage to the affixed tubular pieces all the more likely to occur.

The scaling up of ceramic susceptors has in turn meant that heating of the susceptors is carried out with the susceptor temperature divided into a number of blocks (zones), along with which the number of temperature-measuring probes for measuring the temperature of the susceptor, and the number of electrode terminals and lead lines for supplying power to the susceptor have thus grown. Consequently, because the number of hollow tubular pieces that house these components has also increased, and because in some instances solid columnar pieces are installed on susceptors, the risk that the tubular pieces and columnar pieces will be damaged has also grown all the greater.

Disclosure of Invention

An object of the present invention, in view of such circumstances to date, is to make available a wafer holder in which when the ceramic susceptor therein is in the process of heating, thermal-stress damage to the plurality of tubular pieces and/or columnar pieces affixed to the susceptor can be prevented, and to make available a high-reliability semiconductor manufacturing apparatus utilizing the wafer holder.

In order to achieve the foregoing objective, a wafer holder of the present invention is for retaining and processing a semiconductor wafer on the holder's ceramic susceptor supported within a reaction chamber by tubular pieces, wherein at least two of the tubular pieces are anchored tubular pieces in which one end is affixed onto the ceramic susceptor and the other end is fixed into the reaction chamber, and is characterized in that letting

the highest temperature the ceramic susceptor attains be $T1$,
the thermal expansion coefficient of the ceramic susceptor be $\alpha 1$,
the highest temperature the reaction chamber attains be $T2$,
the thermal expansion coefficient of the reaction chamber be $\alpha 2$,
the longest separation on the ceramic susceptor between the anchored tubular pieces at normal temperature be $L1$, and
the longest separation on the reaction chamber between the anchored tubular pieces at normal temperature be $L2$,

then the wafer holder satisfies the relational formula:

$$|(T1 \times \alpha 1 \times L1) - (T2 \times \alpha 2 \times L2)| \leq 0.7 \text{ mm}.$$

Another wafer holder that the present invention affords is for retaining and processing a semiconductor wafer on the holder's ceramic susceptor supported within a reaction chamber by tubular pieces and/or support pieces, wherein at least two of the tubular pieces and/or support pieces are anchored tubular pieces and/or support pieces in which one end is affixed onto the ceramic susceptor and the other end is fixed into the reaction chamber, and is characterized in that letting

the highest temperature the ceramic susceptor attains be $T1$,
the thermal expansion coefficient of the ceramic susceptor be $\alpha 1$,
the highest temperature the reaction chamber attains be $T2$,
the thermal expansion coefficient of the reaction chamber be $\alpha 2$,
the longest separation on the ceramic susceptor between the anchored tubular pieces and/or the anchored support pieces at normal temperature be $L1$, and
the longest separation on the reaction chamber between the anchored tubular pieces and/or the anchored support pieces at normal temperature be $L2$,

then the wafer holder satisfies the relational formula:

$$|(T1 \times \alpha 1 \times L1) - (T2 \times \alpha 2 \times L2)| \leq 0.7 \text{ mm}.$$

Preferably in the above-characterized wafer holder of the present invention the thermal expansion coefficient of the ceramic susceptor is $8.0 \times 10^{-6}$/K or less, while the thermal expansion coefficient of the reaction chamber is $15 \times 10^{-6}$/K or more. Likewise, the thermal expansion coefficient of the ceramic susceptor more preferably is $6.0 \times 10^{-6}$/K or less, while the thermal expansion coefficient of the reaction chamber more preferably is $20 \times 10^{-6}$/K or more.

Also preferable in the foregoing wafer holder of the present invention is that the length of the anchored tubular pieces and/or the anchored support pieces from the ceramic susceptor to the reaction chamber be 320 mm or less. It is further preferable that the length of the anchored tubular pieces and/or the anchored support pieces from the ceramic susceptor to the reaction chamber be 150 mm or less, and that the thermal conductivity of the anchored tubular pieces and/or anchored support pieces be 30 W/mK or less.

In the above-described wafer holder of the present invention, the reaction chamber preferably is not water-cooled. In addition in the foregoing wafer holder of the present invention a reflection plate for reflecting heat from the ceramic susceptor preferably is furnished in between the reaction chamber and the ceramic susceptor.

In the foregoing wafer holder of the present invention, it is preferable that the parallelism of each of the anchored tubular pieces and/or the anchored support pieces, the respective ends of which are anchored along the reaction chamber and along the ceramic susceptor, be within 1.0 mm, and more preferable that the parallelism of each of the anchored tubular pieces and/or the anchored support pieces be within 0.2 mm.

In the wafer holder described above of the present invention, an O-ring fixed in the reaction chamber and being for maintaining gastightness against the reaction chamber exterior is preferably provided, wherein the microroughness in the vicinity of where the face of the tubular pieces and/or the support pieces abuts on the O-ring is 5.0 µm or less (Ra). The microroughness in the vicinity of where the face of the tubular pieces and/or the support pieces abuts on the O-ring is more preferably 1.0 µm or less (Ra), and is especially preferably 0.3 µm or less (Ra).

In the aforementioned wafer holder of the present invention, an O-ring fixed in the reaction chamber and being for maintaining gastightness against the reaction chamber exterior is preferably provided, wherein the size of surface defects present in the vicinity of where the face of the tubular pieces and/or the support pieces abuts on the O-ring is 1 mm or less in diameter. The size of surface defects present in the vicinity of where the face of the tubular pieces and/ or the support pieces abuts on the O-ring is more preferably 0.3 mm or less in diameter, and is especially preferably 0.05 mm or less.

Likewise, in the above-described wafer holder of the present invention, it is preferable that the thickness uniformity (parallelism) of the ceramic susceptor and the reaction chamber bottom be 1.0 mm or less; that the parallelism of the ceramic susceptor and the reaction chamber bottom be 0.2 mm or less is more preferable still.

Also preferable in the foregoing wafer holder of the present invention is that the anchored tubular pieces and/ or the anchored support pieces be 150 mm or less in length to the reaction chamber, and that the thermal conductivity of the anchored tubular pieces and/or the anchored support pieces be 30 W/mK or less. Additionally preferable is that the reaction chamber not be water-cooled.

Preferable in the foregoing wafer holder of the present invention is that the principal component of the ceramic susceptor be whichever of alumina, silicon nitride, aluminum nitride or silicon carbide. Likewise, the principal component of the ceramic susceptor more preferably is aluminum nitride, the principal component of the reaction chamber more preferably is either aluminum or an aluminum alloy, and the principal component of the anchored tubular pieces and/ or the anchored support pieces more preferably is either mullite or a mullite-alumina composite.

The present invention also affords semiconductor manufacturing apparatus characterized in being outfitted with an above-described wafer holder. The semiconductor manufacturing apparatus is preferably one that is employed in low-*k* film baking.

Brief Description of Drawings

Fig. 1A is a schematic sectional view depicting one specific example of a wafer holder involving the present invention, having been installed within a reaction chamber;

Fig. 1B is a schematic sectional view depicting a separate specific example of a wafer holder involving the present invention, having been installed within a reaction chamber;

Fig. 2A is a schematic sectional view representing a method, having to do with the present invention, of fixing a ceramic susceptor and a tubular piece by means of glass;

Fig. 2B is a schematic sectional view representing a method, having to do with the present invention, of fixing a ceramic susceptor and a support piece by means of glass;

Fig. 3A is a schematic sectional view representing a method, having to do with the present invention, of fixing a ceramic susceptor and a tubular piece by means of a brazing material;

Fig. 3B is a schematic sectional view representing a method, having to do with the present invention, of fixing a ceramic susceptor and a support piece by means of a brazing material;

Fig. 4A is a schematic sectional view representing a method, having to do with the present invention, of fixing a ceramic susceptor and a tubular piece by screw-fastening;

Fig. 4B is a schematic sectional view representing a method, having to do with the present invention, of fixing a ceramic susceptor and a support piece by screw-fastening;

Fig. 5A is a schematic sectional view representing a method, having to do with the present invention, of fixing a ceramic susceptor and a tubular piece by snug-fitting;

Fig. 5B is a schematic sectional view representing a method, having to do with the present invention, of fixing a ceramic susceptor and a support piece by snug-fitting;

Fig. 6A is a schematic sectional view representing a method, having to do with the present invention, of fixing a ceramic susceptor and a tubular piece by unitizing;

Fig. 6B is a schematic sectional view representing a method, having to do with the present invention, of fixing a ceramic susceptor and a support piece by unitizing;

Fig. 7A is a schematic sectional view illustrating an example of a wafer holder furnished with a plurality of tubular pieces and support pieces, and having been installed within a reaction chamber; and

Fig. 7B is a schematic sectional view illustrating a separate example of a wafer holder furnished with a plurality of tubular pieces and support pieces, and having been installed within a reaction chamber.

Best Mode for Carrying Out the Invention

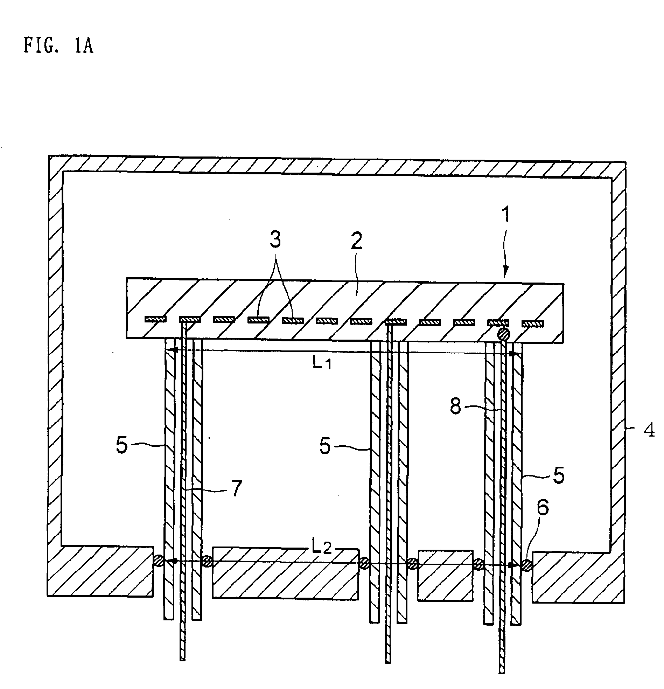

A wafer holder 1 involving the present invention, as illustrated in Fig. 1A for example, is furnished with a ceramic susceptor 2 that includes a resistive heating element 3, and with a plurality of tubular pieces that inside a reaction chamber 4 support the ceramic susceptor 2. Two or more among these tubular pieces are anchored tubular pieces 5 one end of which is affixed to the ceramic susceptor 2 by bonding or a like joining method, while the other end thereof is fixed into the reaction chamber 4 by means of an O-ring 6 or the like. Here, either an electrode terminal/ lead 7 for supplying power to the resistive heating element 3, etc. of the ceramic susceptor 2 in the wafer holder 1, or a temperature-measuring probe 8 for measuring the temperature of the wafer holder 1, is housed in the interior of the anchored tubular pieces 5.

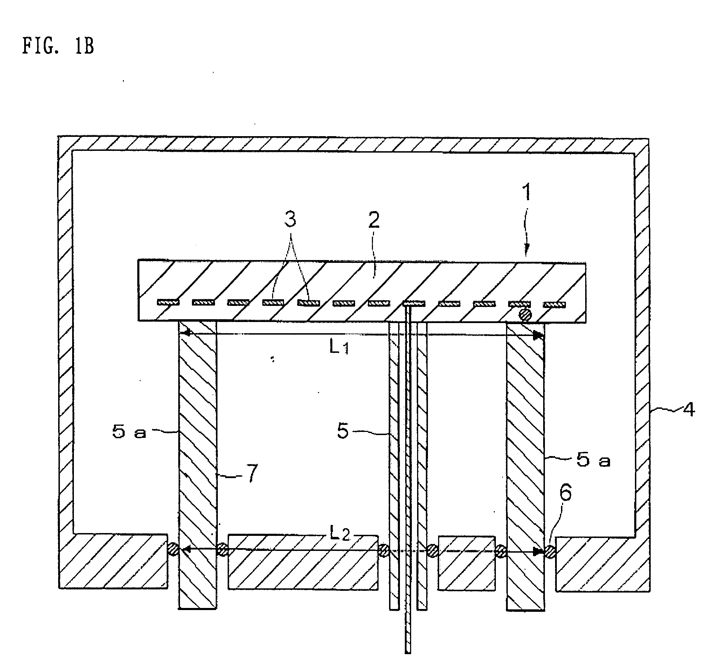

As another embodiment, furthermore, as illustrated in Fig. 1B for example, the wafer holder 1 can also be furnished with the ceramic susceptor 2 that includes the resistive heating element 3, and with a plurality of tubular pieces and/or support pieces that inside a reaction chamber 4 support the ceramic susceptor 2. Two or more among these tubular pieces and/or support pieces are anchored tubular pieces 5 and/or anchored support pieces 5a one end of which is affixed to the ceramic susceptor 2 by bonding or a like joining method; while the other end thereof is fixed into the reaction chamber 4 by means of an O-ring 6 or the like. In this case also, either an electrode terminal/lead 7 for supplying power to the resistive heating element 3, etc. of the ceramic susceptor 2 in the wafer holder 1, or a temperature-measuring probe 8 for measuring the temperature of the wafer holder 1, is housed in the interior of the anchored tubular pieces 5.

Thus the ceramic susceptor 2 of the wafer holder 1 may be supported by tubular pieces that can contain an electrode terminal/lead 7, or a temperature-measuring probe 8 such as a thermocouple, and may be provided with support members apart from the tubular pieces-with solid support pieces for example. Moreover, employing tubular pieces and/or support pieces that are not anchored to the ceramic susceptor 2 and/or the reaction chamber 4 is also possible. It should be understood that even in these cases, what the subject matter of the present invention is relates to tubular pieces and support pieces that are anchored to ceramic susceptors and reaction chambers.

The anchored tubular pieces 5 and/or support pieces 5a affixed to the ceramic susceptor 2 become heated by heat applied to the ceramic susceptor 2 when a wafer is being processed, and this heat, transmitted to anchored tubular pieces 5 and/or support pieces 5a, is in turn transmitted to the reaction chamber 4. Moreover, heat is also transmitted to the reaction chamber 4 due to the emanation or radiation and convection of heat from the ceramic susceptor 2. The ceramic susceptor 2 and the reaction chamber 4 therefore expand thermally. In that situation, anchored tubular pieces 5 and/or support pieces 5a undergo stress corresponding to the difference in the amounts by which the ceramic susceptor 2 and the reaction chamber 4 expand thermally; in cases where the stress is great enough, damage occurs.

As a result of investigating in detail the relationship between the amount of thermal expansion by the ceramic susceptor and the reaction chamber, and damage to the anchored tubular pieces and/or support pieces, it was understood that if the difference between the two in thermal-expansion extent exceeded 0.7 mm, the anchored tubular pieces and/or support pieces would be damaged by stress. Therefore, in a wafer holder of the present invention the difference on the ceramic susceptor and on the reaction chamber in longest inter-piece distance among the plurality of anchored tubular pieces and/or support pieces when the maximum susceptor temperature has been attained is predetermined so as to be 0.7 mm or less.

Namely, as illustrated exemplarily in Fig. 1A, with the present invention, in a wafer holder 1 in which a ceramic susceptor 2 that includes a resistive heating element 3 is supported inside a reaction chamber 4 by a plurality of anchored tubular pieces 5, and along their distal ends the anchored tubular pieces 5 are hermetically sealed into the reaction chamber 4 by means of an O-ring 6, letting

the highest temperature the ceramic susceptor 2 attains be *T1*,

the thermal expansion coefficient of the ceramic susceptor 2 be $\alpha 1$,

the highest temperature the reaction chamber 4 attains be *T2*,

the thermal expansion coefficient of the reaction chamber 4 be $\alpha 2$,

the longest separation on the ceramic susceptor 2 between the anchored tubular pieces 5 at normal temperature be *L1*, and

the longest separation on the reaction chamber 4 between the anchored tubular pieces 5 at normal temperature be *L2*,

then the abovementioned *L1* and *L2* are predetermined so as to satisfy the relational formula:

$$|(T1 \times \alpha 1 \times L1) - (T2 \times \alpha 2 \times L2)| \leq 0.7 \text{ mm.}$$

Furthermore, in the present invention as illustrated in Fig. 1B for example, in a wafer holder 1 in which a ceramic susceptor 2 is supported within a reaction chamber by tubular pieces and/or support pieces, with at least two of the tubular pieces and/or support pieces being anchored tubular pieces 5 and/or anchored support pieces 5a one end of which is affixed to the ceramic susceptor and the other end of which is fixed into the reaction chamber, so that *T1*, the highest temperature the ceramic susceptor 2 attains, $\alpha 1$, the thermal expansion coefficient of the ceramic susceptor 2, *T2*, the highest temperature the reaction chamber 4 attains, $\alpha 2$, the thermal expansion coefficient of the reaction chamber 4, *L1*, the longest inter-piece distance on the ceramic susceptor 2 among the anchored tubular pieces 5 and/or anchored support pieces 5a at normal temperature, and $L2$, the longest inter-piece distance on the reaction chamber 4 among the anchored tubular pieces 5 and/or anchored support pieces 5a at normal temperature satisfy the relational formula $|(T1 \times \alpha1 \times L1) - (T2 \times \alpha2 \times L2)| \leq 0.7$ mm,
$L1$ and $L2$ are predetermined.

Herein, the inter-piece distances among the anchored tubular pieces and/or anchored support pieces (including-identically hereinafter-the inter-piece distances among the anchored tubular pieces in Fig. 1A) are the separations between them, taking the outer dimension of each, measured on the ceramic susceptor and on the reaction chamber to which they are joined. It will be appreciated that in the above-stated relational formula $(T1 \times \alpha1 \times L1)$ expresses the longest inter-piece distance among the anchored tubular pieces and/or anchored support pieces along the ceramic susceptor when the susceptor has reached maximum temperature, while $(T2 \times \alpha2 \times L2)$ expresses the longest inter-piece distance among the anchored tubular pieces and/or anchored support pieces along the reaction chamber when the susceptor has reached maximum temperature.

Because in general the tubular pieces and/or support pieces are anchored so as each to be orthogonal with respect to the ceramic susceptor and the reaction chamber, the inter-piece distance on the susceptor end and on the chamber end between two anchored tubular pieces and/or anchored support pieces will ordinarily be the same. But even such being the case, due to such factors as the difference in thermal expansion coefficient between the susceptor and the reaction chamber while the ceramic susceptor is heating, the longest inter-piece distance among the plurality of anchored tubular pieces and/or anchored support pieces will as a matter of course come to differ on the susceptor end and on the chamber end.

Given these circumstances, in accordance with the present invention, in instances like Fig. 1A in which the ceramic susceptor is supported on tubular pieces only, if from the foregoing relational formula the discrepancy $|(T1 \times \alpha1 \times L1) - (T2 \times \alpha2 \times L2)|$ in the longest separation between anchored tubular pieces in the plurality would be greater than 0.7 mm while the ceramic susceptor is heating-for example, if on the reaction-chamber end the longest separation grows 1.0 mm longer-by setting in advance the separation at normal temperature between the anchored tubular pieces on the ceramic-susceptor end so as during heating to lengthen greater than on the chamber end by 0.3 mm or more, the discrepancy in the longest separation between the anchored tubular pieces can be controlled to stay within 0.7 mm or less even during use at the highest attained temperature. Conversely, moreover, if on the ceramic-susceptor end the longest separation is greater, damage to the tubular pieces can be prevented by making at normal temperature the separation on the reaction-chamber end longer than that on the susceptor end to satisfy the foregoing relational formula.

In addition, the present invention is also applicable to cases in which the ceramic susceptor is not supported on tubular pieces only-for example, to cases, as illustrated in Fig. 1B, in which a ceramic susceptor is supported by means of support pieces. In cases such as this as well, with at least two of the tubular pieces and/or support pieces being anchored tubular pieces and/or anchored support pieces one end of which is affixed to the ceramic susceptor and the other end of which is fixed into the reaction chamber, if from the foregoing relational formula the discrepancy $|(T1 \times \alpha1 \times L1) - (T2 \times \alpha2 \times L2)|$ in the longest separation between anchored tubular pieces and/or anchored support pieces in the plurality would be greater than 0.7 mm while the ceramic susceptor is heating-for example, if on the reaction-chamber end the longest separation grows 1.0 mm longer-by setting in advance the separation at normal temperature between the anchored tubular pieces and/or the anchored support pieces on the ceramic-susceptor end so as during heating to lengthen greater than on the chamber end by 0.3 mm or more, the discrepancy in the longest separation between the anchored tubular pieces and/or anchored support pieces can be controlled to stay within 0.7 mm or less even during use at the highest attained temperature. Conversely, moreover, if on the ceramic-susceptor end the longest separation is greater, damage to the anchored tubular pieces and/or anchored support pieces can be prevented by making at normal temperature the separation on the reaction-chamber end longer than that on the susceptor end to satisfy the foregoing relational formula.

Another problematic circumstance has been that due to thermal expansion of the ceramic susceptor and reaction chamber while the susceptor is heating, the positions of the plurality of anchored tubular pieces and/or anchored support pieces relative to one another vary. This runs the risk that in general the O-rings, which are made of rubber, installed between t the anchored tubular pieces and/or anchored support pieces and the reaction chamber will deform, degrading the gastightness of the reaction chamber interior.

In this situation, nevertheless, preconfiguring the discrepancy in the longest separation between the anchored tubular pieces and/or anchored support pieces in the foregoing relational formula to be 0.3 mm or less-i.e.$|(T1 \times \alpha1 \times L1) - (T2 \times \alpha2 \times L2)| \leq 0.3$ mm-will nearly eliminate degradation in gastightness and thus be that much more beneficial. Specifically, with the just-noted discrepancy in the longest separation between the anchored tubular pieces and/or anchored support pieces being 0.3 mm or less, a gastightness of $10^{-9}$ Pam$^3$/s or less given as helium leak rate may be secured. Moreover, it is possible to ensure a value of $10^{-7}$ Pam$^3$/s or less even if the discrepancy in the longest separation between the anchored tubular pieces and/or anchored support pieces is as much as 0.7 mm. It should be understood that in drawing the reaction chamber interior down to a vacuum at normal temperatures there are generally no problems at all with gastightness.

In the present invention the shape of the tubular pieces, which can house leads/electrode terminals for supplying electricity to the temperature-measuring probes and the resistive heating element, does not matter as long as it is tubular. On the other hand, the support pieces in the present invention are not particularly limited as to their geometry-circularly or quadrangularly columnar, tubular, etc.-as long as they can support the ceramic susceptor. Also, the tubular pieces and support pieces do not have to be affixed to the ceramic susceptor and to the reaction chamber; the tubular pieces and support pieces in such cases would not come under the applicability of the present invention. And as far as the way in which the ceramic susceptor and the anchored tubular pieces and/or anchored support pieces are fixed is concerned, as long as the anchoring method is such that the separation between the anchored tubular pieces and/or anchored support pieces varies along with the thermal expansion of the susceptor, all anchoring methods are applicable.

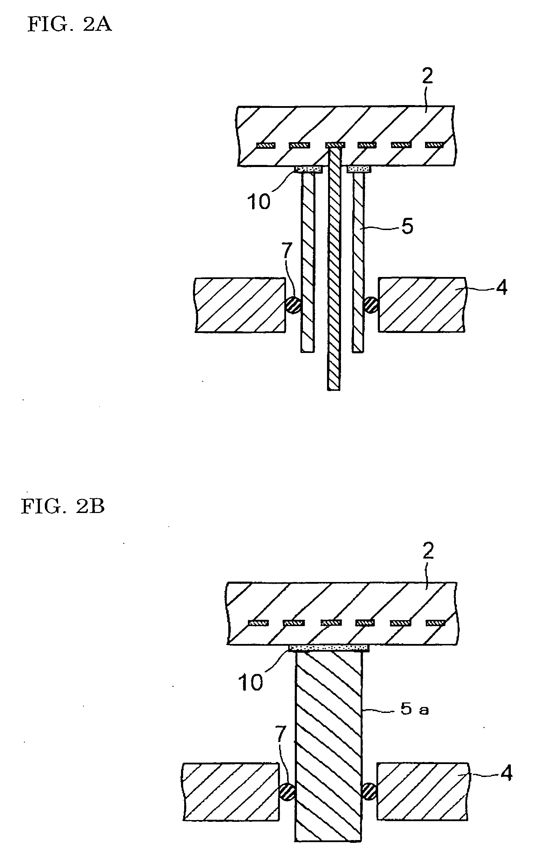

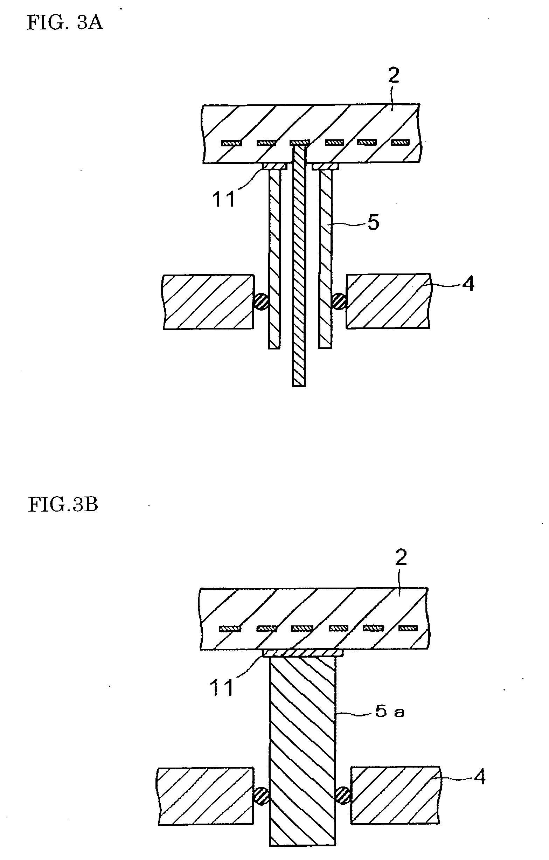

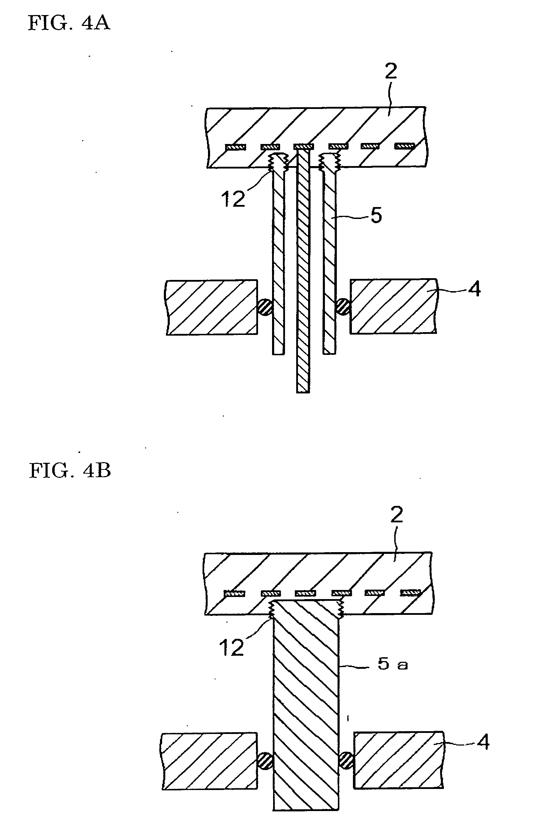

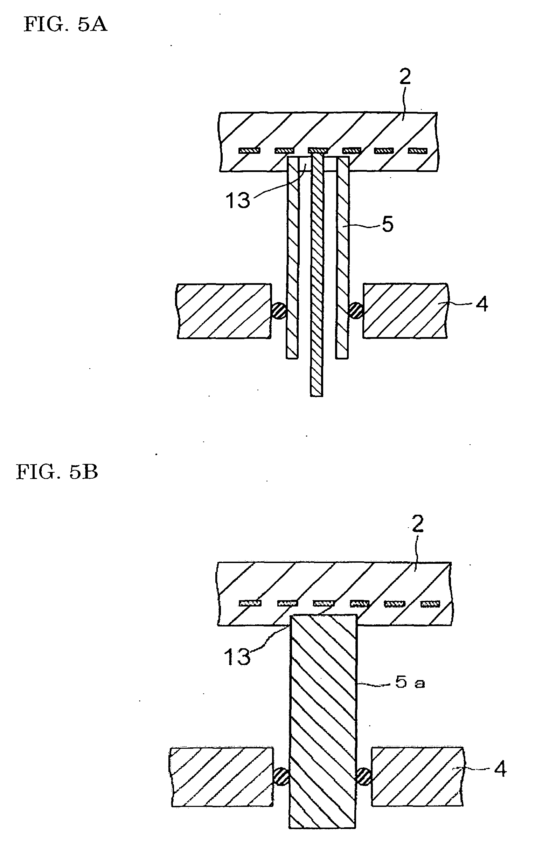

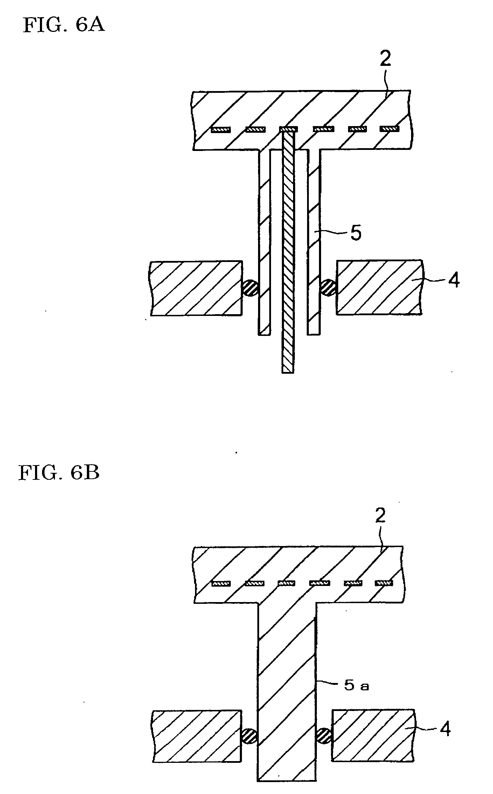

Examples include, as illustrated in Figs. 2a and 2B, the anchored tubular pieces 5 and/or anchored support pieces 5a being bonded with glass 10 to the surface on the side (back side) of the ceramic susceptor 2 opposite its wafer-heating side and, as illustrated in Figs. 3A and 3B, being bonded by means of a brazing material. An alternative, as illustrated in Figs. 4A and 4B, is to fasten the anchored tubular pieces 5 and/or anchored support pieces 5a into the ceramic susceptor 2 with a screw-fastening 12 by forming a female screw in the susceptor back side, and into that screwing a male screw on the tubular piece. Anchoring can also be, as illustrated in Figs. 5A and 5B, by forming a spot facing 13 in the back side of the ceramic susceptor 2 and into that snuggly fitting one end of the anchored tubular pieces 5 and/or anchored support pieces 5a. Optionally, as illustrated in Figs. 6A and 6B, also possible is forming the anchored tubular pieces 5 and/or anchored support pieces 5a unitarily with the ceramic susceptor 2. As regards anchored tubular pieces, it should be understood that supporting the susceptor with anchored tubular pieces alone is also possible; likewise, providing special support pieces apart from the anchored tubular pieces is also possible.

On the other hand, the configuration between the tubular pieces and/or the support pieces and the reaction chamber uses O-rings or another means to keep the reaction chamber interior airtight, in order to maintain a vacuum or otherwise low-pressure state within the reaction chamber while the ceramic susceptor is heating (during wafer processing).

A preferable thermal expansion coefficient for of the ceramic susceptor is $8.0 \times 10^{-6}$/K or less; a preferable thermal expansion coefficient for the reaction chamber is $15 \times 10^{-6}$/K or more. The thermal expansion coefficient of the reaction chamber is made larger than that of the ceramic susceptor in order to hold down the amount by which the ceramic susceptor expands thermally, and conversely to increase the amount by which the reaction chamber expands thermally, to match the thermal expansions of the two, because when the susceptor is heating the temperature of the susceptor is relatively higher than that of the reaction chamber. Moreover, having the thermal expansion coefficient of the ceramic susceptor be $6.0 \times 10^{-6}$/K or less, and the thermal expansion coefficient of the reaction chamber be $20 \times 10^{-6}$/K or more, is especially beneficial in that it lessens restrictions on the viable temperature range for the ceramic and on the locations where the anchored tubular pieces and/or anchored support pieces can be attached.

As regards the reaction chamber, demands for scaled-down versions have been intense in recent years. For that reason the thermal conductivity of the tubular pieces and support pieces ideally should be 200 W/mK or less because then it is possible to have the length from the ceramic susceptor to the reaction chamber be 320 mm or less. Conversely, the thermal conductivity of the tubular pieces and support pieces being in excess of 200 W/mK is undesirable because the heat generated in the susceptor and transmitted through the tubular pieces and support pieces elevates the reaction chamber temperature such that it surpasses the O-ring's level of heat resistance, compromising the gastight integrity of the reaction chamber interior.

In addition, the reaction chamber structure preferably is one that is not water-cooled because, as stands to reason, attaching a water-cooling device to the chamber complicates the apparatus. It is also preferable that the length (distance) of the anchored tubular pieces and/or anchored support pieces from the ceramic susceptor to the reaction chamber be 150 mm or less, because the longer the length of anchored tubular pieces and/or anchored support pieces is, the larger the scale of the reaction chamber itself will have to be.

In order for the just-noted length of anchored tubular pieces and/or anchored support pieces to be established at 150 mm or less without the reaction chamber being water-cooled, conduction of heat from anchored tubular pieces and/or anchored support pieces to the reaction chamber must be restrained. For this reason, the thermal conductivity of anchored tubular pieces and/or anchored support pieces preferably is 30 W/mK or less. Making the thermal conductivity of anchored tubular pieces and/or anchored support pieces 30 W/mK or less also lessens the amount of heat that escapes from the ceramic susceptor to anchored tubular pieces and/or anchored support pieces, which enhances temperature uniformity in the wafer-heating face of the ceramic susceptor.

From a temperature uniformity point of view, alumina, mullite, and composites of alumina and mullite, as well as stainless steels are employable as a specific material for anchored tubular pieces and/or anchored support pieces. Using such materials affords a semiconductor manufacturing apparatus in which-with the length of anchored tubular pieces and/or anchored support pieces to the reaction chamber being within 150 mm, and with the structure, in not using water cooling in the reaction chamber, being simple-reduction of scale is enabled, and in which temperature uniformity in the susceptor wafer-heating face is outstanding.

Here, what may be housed inside the tubular pieces is, to give examples, leads for supplying power to a resistive heating element within the ceramic susceptor, RF electrodes for generating plasma, and leads for supplying power to electrostatic chuck electrodes that are for anchoring wafers. In addition, temperature-measuring probes for gauging the temperature of the ceramic may also be contained therein.

In addition, placing a reflection plate that reflects heat from the ceramic susceptor in between the reaction chamber and the susceptor is also possible. The power consumed by the susceptor can be reduced by installing a reflection plate, because heat from the susceptor is reflected back. Although in this case there are no particular restrictions as to where the reflection plate is installed, nearer the ceramic susceptor than the midpoint between the bottom of the reaction chamber and the susceptor is preferable because that way allows heat to be reflected efficiently.

The microroughness of the reflection plate preferably is 1.0 μm or less (Ra). For the reflection plate to be of microroughness greater than this would be disadvantageous because of the higher proportion, within the heat reflected from the ceramic susceptor, of heat absorbed by the reflection plate. Especially preferable is that the surface be in mirror-like condition-that is, 0.1 μm or less roughness average (Ra). As to further properties of the reflection plate, there are no particular restrictions as to its substance as long as it is inert with respect to the gases employed within the reaction chamber, and, against the temperatures at which the ceramic susceptor is employed, has the level of heat resistance at which deformations will not arise. Examples that may be mentioned include metals such as aluminum, stainless steel and nickel; and ceramics such as alumina, silicon carbide, silicon nitride and alum nitride.

As to specifics of the anchored tubular pieces and/or anchored support pieces the respective ends of which are affixed along the reaction chamber and along the ceramic susceptor, they preferably have a parallelism that is within 1.0 mm. Parallelism greater than this is undesirable because in mounting the wafer holder in the reaction chamber, stress excessive enough to be damaging would be applied to the anchored tubular pieces and/or anchored support pieces affixed to the susceptor. Such damage can be prevented if the parallelism of the anchored tubular pieces and/or anchored support pieces affixed to the susceptor is within 1.0 mm, because then the capacity of the hermetically sealing O-rings to deform will alleviate stress produced between the ceramic susceptor and the anchored tubular pieces and/or anchored support pieces. In particular, it is especially preferable that the parallelism be within 0.3 mm, because then the O-ring-effected gastight seal can be made to be-given as helium leak rate-$10^{-9}$ Pam$^3$/s or less.

Again, O-rings are employed for a gastight seal between the reaction chamber and the tubular pieces and/or support pieces. Therein the microroughness in the vicinity of where on the face of the tubular pieces and/or support pieces the O-ring abuts is preferably Ra $\leq$ 5.0 μm. For the face to have a microroughness above this level would be undesirable because achieving a vacuum of $10^{-7}$ Pam$^3$/s or less would be exceedingly difficult, even if vacuum grease is used on the face of the tubular pieces and/or support pieces in the vicinity O-ring abutment. With the microroughness being Ra $\leq$ 5.0 μm, and if vacuum grease is employed, then a vacuum of $10^{-7}$ Pam$^3$/s or less can be achieved. Likewise, if the microroughness of the abutment surface is Ra $\leq$ 1.0 μm, then a vacuum of $10^{-7}$ Pam$^3$/s or less can be achieved even if vacuum grease is not used. Moreover, the microroughness being Ra $\leq$ 0.3 μm is particularly ideal, because then a vacuum of $10^{-9}$ Pam$^3$/s or less can be achieved even if vacuum grease is not used.

And again, the size of surface defects in the vicinity of where on the face of the tubular pieces and/or support pieces the O-ring abuts preferably is 1 mm or less in diameter. For defects of magnitude greater than that to be present in the vicinity of the abutment area would be detrimental because achieving a vacuum of $10^{-7}$ Pam$^3$/s or less would be exceedingly difficult, even if vacuum grease is used. By the same token, with the magnitude of the defects being 1.0 mm or less in diameter a vacuum of $10^{-7}$ Pam$^3$/s or less can be achieved by employing vacuum grease. Furthermore, if the magnitude of defects present in the vicinity of the abutment area is 0.3 mm or less in diameter, then a vacuum of $10^{-7}$ Pam$^3$/s or less can be achieved even if vacuum grease is not used. Still further, the defect magnitude being 0.05 mm or less in diameter is particularly ideal, because then a vacuum of $10^{-9}$ Pam$^3$/s or less can be achieved even if vacuum grease is not used.

The thickness uniformity of the ceramic susceptor and the reaction chamber bottom preferably is within 1.0 mm. Thickness uniformity in excess of this is undesirable because it can lead to wafer drop-off when wafers are mounted onto and demounted from the wafer holder. In particular, when the wafer is set onto the wafer holder, lift pins-3 ordinarily being present-support the wafer in the space over the ceramic susceptor. Therein, the positions of the lift-pin tips are preset so that the plane they form is parallel to the reaction chamber. Then by the lowering of the three lift pins the wafer is installed on the wafer-carrying side of susceptor.

If, however, in this situation the thickness uniformity of the ceramic susceptor and reaction chamber exceeds 1.0 mm, in the interval until the lift pins have descended the wafer will end up coming into contact with the susceptor. This means that the wafer will be put into a state in which it is supported by two of the lift pins and the susceptor wafer-carrying side; and when the lift pins have descended, the wafer, being at an incline, will at times drop off or will end up slipping out of the wafer-carrying location. With the parallelism of the ceramic susceptor and reaction chamber being 1.0 mm or less danger of drop-off is eliminated; moreover, a parallelism of 0.2 mm or less is advantageous because such displacement as to become a hindrance to wafer processing will not arise. It should be noted that "wafer displacement" means, for example, the riding up of a wafer on the rim of the wafer pocket formed in the susceptor wafer-carrying side.

Although it does not particularly matter what the material for the ceramic susceptor employed in the present invention is, preferable is one in which the chief component is whichever of alumina, silicon nitride, aluminum nitride, and silicon carbide. Because demands for uniformization of temperature distribution in ceramic susceptors have grown intense in recent years, materials of high thermal conductivity-specifically, materials whose thermal conductivity exceeds 100 W/mK, such as aluminum nitride and silicon carbide-are preferable, with aluminum nitride being particularly preferable owing to the superiority of its corrosion resistance and insulating properties. Meanwhile silicon nitride, because the strength of the ceramic itself at elevated temperatures is high compared with other ceramics, is ideal particularly for susceptors employed at high temperatures. Another advantage of silicon nitride, aluminum nitride, and silicon carbide is their superior resistance to thermal shock, such that these ceramics are capable of rapid rise and fall in temperature. Alumina stands out meanwhile in that from a cost aspect it is superior compared with other ceramics. The choice as to which of these ceramics to use will as a matter of course depend on the application.

Of the foregoing ceramic-susceptor substances aluminum nitride and silicon carbide are, on account of the temperature uniformity demanded of wafer holders in recent years, preferable; while aluminum nitride, whose corrosion resistance against every sort of corrosive gas employed is high, is especially preferable. Concerning the amount of sintering additive contained in the aluminum nitride, 0.05 weight % or more, 3.0 weight % or less is especially preferable. An amount of sintering additive lower than this is unadvisable in that because inter-grain interstices will be present in the sintered aluminum nitride compact, leading to etching from the interstitial areas, particles will be generated. On the other hand, with components of the additive persisting along the grain boundaries of the aluminum nitride grains if the amount of sintering additive is in excess of 3.0 weight %, there will be etching from the additive components, in which case also particles will be produced.

There are no particular restrictions with regard to the reaction-chamber substance. With metals, for example, aluminum or aluminum alloys, nickel or nickel alloys, and stainless steels may be employed. Although there are no particular restrictions with ceramics either, substances such as alumina or cordierite may be employed.

Turning to what the substance of the tubular pieces is, given the fact that leads for supplying power to the resistive heating element, RF electrodes, and electrostatic-chuck electrodes are contained in them, they advisably are an insulator. This is because if electrical continuity is created in between the tubular piece and the leads, under low pressure and under a vacuum, problems such as sparks being generated between the electrodes and being conducted into the reaction chamber will arise. Inorganic materials such as ceramics are, to be specific, preferable.

A further consideration is that in cases in which among these tubular pieces, the anchored tubular pieces affixed to the ceramic susceptor are bonded with glass or a brazing material, the difference in thermal expansion coefficient between the anchored tubular piece and the susceptor should be small. In specific terms, it is preferable that the difference between the thermal expansion coefficient of the anchored tubular pieces at normal temperature, and the thermal expansion coefficient of the ceramic susceptor at normal temperature be $5.0 \times 10^{-6}$/K or less. A thermal-expansion-coefficient discrepancy in excess of this existing between the two would be unadvisable because when being joined the ceramic susceptor and anchored tubular pieces would break, or would be subject to cracking. Nevertheless, this restriction does not apply in cases in which the tubular pieces are not joined directly to the ceramic susceptor, but are affixed to it by screw-fastening or the like.

Specifically, while for the tubular-piece substance it is possible to use the same substance as that of the ceramic susceptor, using mullite, alumina or sialon is also possible, as is using silicon nitride. These substances are preferable because with their thermal conductivity being comparatively low, they make for lowered heat transmission from the susceptor to the reaction chamber. It should be understood that even with tubular pieces there are no particular restrictions on what their substance is in cases in which they do not contain leads, etc.

Meanwhile there are no particular restrictions regarding the support-piece substance. The use of a variety of materials such as various ceramics and metals, or composites and the like of ceramics and metals is possible. In particular, the appropriate selection may be made depending on the environment in which the ceramic susceptor is employed.

With regard to the substance of anchored support pieces, which among the various support pieces are affixed to the ceramic susceptor, in cases in which they are joined on using glass or a brazing material, the difference in thermal expansion coefficient between the anchored support pieces and the susceptor should be small. To be specific, the difference in the thermal expansion coefficient of the anchored support pieces at normal temperature, and the thermal expansion coefficient of the ceramic susceptor at ordinary temperature preferably is $5.0 \times 10^{-6}$/K or less. A thermal-expansion-coefficient discrepancy in excess of this, present between the two, would be detrimental because when being joined together, the ceramic susceptor or the tubular pieces would be damaged, or cracks would arise in them. Nevertheless, this restriction does not apply in cases in which the support pieces are not joined directly to the ceramic susceptor, but are affixed to it by screw-fastening or the like.

With regard to specific support-piece substances, although employing the same substance as that of the ceramic susceptor is possible, using mullite, alumina or sialon is also possible, as is using silicon nitride. These substances are preferable because with their thermal conductivity being comparatively low, they make for lowered heat transmission from the susceptor to the reaction chamber.

From the above, aluminum nitride is especially preferable as a ceramic-susceptor substance, and for the substance of the anchored tubular pieces and/or anchored support pieces that are attached to it, mullite and mullite-alumina composites are especially preferable in that their thermal expansion coefficients match that of aluminum nitride, and also for their low thermal conductivity. In turn, aluminum or aluminum alloys are especially preferable as a reaction-chamber substance for their matching of thermal expansion coefficient in terms of the combined assembly. In actual apparatuses, corrosive gases will sometimes be employed depending on the situation, and therefore the selection of substances corresponding to the application will of course be critical.

Then, utilizing a wafer holder in the present invention makes available a highly reliable semiconductor manufacturing apparatus in which there is no damage to the anchored tubular pieces that serve to contain electrode terminals/leads for the ceramic susceptor and to contain temperature gauging probes as well, nor to anchored tubular pieces and/or anchored support pieces that simply support the susceptor. In particular, among the variety of semiconductor manufacturing apparatuses that there are, this will be especially suitable as an apparatus for low-*k* film baking, in which the restrictions on the materials that may be introduced into the reaction chamber are few.

Embodiments

*Embodiment One*

Slurries were prepared by putting a predetermined amount of sintering additive in the ceramic powders set forth in Table I below, furthermore adding a solvent or the like and blending the mixture together with a ball mill. Granules were prepared from the slurry by spray-drying it, and the obtained granules were press-molded using dies of predetermined form. The molded objects thus produced were degreased and then sintered at respective predetermined temperatures into sintered ceramic compacts. The thermal expansion coefficient and thermal conductivity of each of the sintered ceramic compacts obtained were measured, and together are set forth in Table I.

Table I

| Sample | Susceptor chief component | Sintering additive (add. amt.) | Therm. exp. coeff. ($\times 10^{-6}$/K) | Thermal conductivity (W/mK) |
|---|---|---|---|---|
| 1 | Aluminum nitride | — | 4.5 | 110 |
| 2 | Aluminum nitride | $Y_2O_3$ (0.05%) | 4.5 | 150 |
| 3 | Aluminum nitride | $Y_2O_3$ (0.5%) | 4.5 | 180 |
| 4 | Aluminum nitride | $Y_2O_3$ (1.0%) | 4.5 | 180 |
| 5 | Aluminum nitride | $Y_2O_3$ (5.0%) | 4.5 | 170 |
| 6 | Aluminum nitride | $Eu_2O_3$ (0.5%) | 4.5 | 180 |
| 7 | Aluminum nitride | $Nd_2O_3$ (0.5%) | 4.5 | 180 |
| 8 | Silicon carbide | — | 3.8 | 220 |
| 9 | Alumina | MgO (0.5%) | 7.8 | 28 |
| 10 | Silicon nitride | $Y_2O_3$(0.5%) | 3.8 | 25 |
| 11 | Aluminum nitride | $Y_2O_3$(3.0%) | 4.5 | 180 |

Using a screen-printing technique, a resistive heating element was formed and, according to requirements, RF electrodes and electrostatic-chuck electrodes were fashioned, onto substrates respectively constituted from the sintered ceramic materials noted above. Each printed substrate was baked under predetermined conditions, and a ceramic plate was bonded over it in order to protect the resistive heating element, RF electrodes, and electrostatic-chuck electrodes printed as needed. A wafer pocket for carrying a wafer was formed by a machining operation, and then electrode terminals and leads for connecting to electrical circuits were installed, into the ceramic susceptors thus produced.

Anchored tubular pieces and/or anchored support pieces constituted from the substances set forth in Table II below were attached and anchored to the surface on the side (back side) of each ceramic susceptor opposite its wafer-heating side. Utilized as anchoring methods were: bonding by means of glass, represented in Figs. 2A and 2B; bonding by means of a brazing material used in active metal brazing, represented in Figs. 3A and 3B; anchoring by means of screws, represented in Figs. 4A and 4B; snug-fitting into a spot facing in the back side of the ceramic susceptor, represented in Figs. 5A and 5B; and a type of anchoring in which either the tubular pieces or the support pieces are unitary with the ceramic susceptor, represented in Figs. 6A and 6B. Here, all the tubular pieces that were used were 10 mm in outside diameter and 6 mm in inside diameter. In turn, all the support pieces that were used were in the form of solid columns of 10 mm outside diameter. With the Figs. 5A and 5B snug-fitting instances, the spot facing depth was made 3 mm, and the diameter, 10.1 mm. In those tubular pieces made of metal only a thermocouple was housed, whereas electrode terminals and leads were housed within the other tubular pieces.

Table II

| Tubular piece substance | Thermal expansion coefficient ($\times 10^{-6}$/K) | Thermal conductivity (W/mK) |
|---|---|---|
| Aluminum nitride | 4.5 | 180 |
| Silicon nitride | 3.2 | 25 |
| Alumina | 7.8 | 28 |
| Silicon carbide | 3.8 | 220 |
| Mullite | 4.5 | 1 |
| Nickel | 13 | 80 |
| Stainless steel | 7.9 | 17 |
| Tungsten | 4.5 | 170 |
| Molybdenum | 5 | 150 |

Herein, the parallelism of each of the tubular pieces and/or support pieces attached to the ceramic susceptor was measured, wherein it was within 0.1 mm in every case. Likewise, the microroughness in the vicinity of the O-ring abutment area of the attached tubular pieces and/or support pieces was in each instance Ra $\leq 0.3\,\mu$m , and as a result of observing the surface under an optical microscope, that there were no defects exceeding 0.05 mm was verified.

For the wafer holders thus fabricated, reaction chambers of predetermined configuration, constituted from the substances set forth in Table III below, were readied. The wafer holders were installed within the reaction chambers, and were sealed gastight by means of an O-ring made of rubber in between the tubular pieces and/or support pieces and the chamber. Therein, the parallelism of the wafer-carrying side of the ceramic susceptor and the reaction chamber was 0.15 mm or less in every case. Following that, power was supplied to the ceramic susceptors to raise their temperature to a predetermined level, the temperature of the ceramic susceptors and of the reaction chambers was measured with the thermocouple, and then the temperature uniformity of the ceramic susceptor was found. The temperature was then lowered to the normal level, and the tubular pieces and/or support pieces were checked for damage.

Table III

| Reaction chamber substance | Thermal expansion coefficient ($\times 10^{-6}$/K) | Thermal conductivity (W/mK) |
|---|---|---|
| Nickel | 13 | 80 |
| Stainless steel | 7.9 | 17 |
| Alumina | 7.8 | 28 |
| Aluminum | 23 | 200 |

The results obtained are set forth, by ceramic-susceptor (heater) and anchored-tubular-piece and/or anchored-support-piece substance, in the following Tables IV-XLV, divided into test conditions and test results. In the tests, the atmosphere within the reaction chamber while the ceramic susceptors were heating was made a vacuum. The temperature uniformity of the susceptors was measured using a wafer-temperature gauge. Also, gastightness between the reaction chamber, and the tubular pieces and/or support pieces is indicated in the tables as "V. good" where the leak rate was $10^{-9}$ Pam$^3$/s or less while the temperature was high, and as "Good" where it was $10^{-7}$ Pam$^3$/s or less.

Table IV

| Test conditions Heater substance: 3 (Aluminum nitride) | | | | | | |
|---|---|---|---|---|---|---|
| Sample | Tubular piece | | | Chamber subst. | Inter-piece separation at normal temperature | |
| | Substance | Fixing means | Length (mm) | | Heater end (L1) | Chamber end (L2) |
| 3-1 | Mullite | Glass | 100 | Al | 300 | 300 |
| 3-2 | Mullite | Glass | 100 | Al | 300 | 300 |
| 3-3 | Mullite | Screws | 100 | Al | 300 | 300 |
| 3-4 | Mullite | Snugging | 100 | Al | 300 | 300 |
| 3-5 | AlN | Glass | 100 | Al | 300 | 300 |
| 3-6 | AlN | Snugging | 150 | Al | 300 | 300 |
| 3-7 | AlN | Glass | 150 | Al | 300 | 300 |
| 3-8 | AlN | Screws | 150 | Al | 300 | 300 |
| 3-9 | AlN | Screws | 150 | Al | 299.5 | 300 |
| 3-10 | AlN | Screws | 150 | Al | 300 | 300.5 |
| 3-11 | AlN | Unitary type | 150 | Al | 300 | 300.5 |
| 3-12 | $Si_3N_4$ | Glass | 150 | Al | 300 | 300 |
| 3-13 | $Al_2O_3$ | Glass | 150 | Al | 300 | 300 |
| 3-14 | $Al_2O_3$ | Snugging | 150 | Al | 300 | 300 |
| 3-15 | SiC | Glass | 150 | Al | 300 | 300 |
| 3-16 | Ni | Brazing material | 150 | Al | 300 | 300 |
| 3-17 | W | Brazing material | 150 | Al | 300 | 300 |
| 3-18 | W | Snugging | 150 | Al | 300 | 300 |
| 3-19 | Mo | Brazing material | 150 | Al | 300 | 300 |
| 3-20 | Stainless steel | Screws | 150 | Al | 300 | 300 |

Table V

| Test results Heater substance: 3 (Aluminum nitride) | | | | | | |
|---|---|---|---|---|---|---|
| Sample | Use temp. (°C) | | Inter-piece separation discrepancy when heated | Gastightness | Temp. uniformity (%) | Notes |
| | Heater | Chamber | | | | |
| 3-1 | 500 | 95 | 0.02 mm | V. good | ±0.2 | Excellent |
| 3-2 | 850 | 150 | 0.11 mm | V. good | ±0.2 | |
| 3-3 | 850 | 145 | 0.15 mm | V. good | ±0.2 | |

Table V   (continued)

| Test results Heater substance: 3 (Aluminum nitride) | | | | | | |
|---|---|---|---|---|---|---|
| Sample | Use temp. (°C) | | Inter-piece separation discrepancy when heated | Gastightness | Temp. uniformity (%) | Notes |
| | Heater | Chamber | | | | |
| 3-4 | 850 | 145 | 0.15 mm | V. good | ±0.2 | |
| 3-5 | 850 | — | | | | O-ring damage |
| 3-6 | 800 | 50 | 0.73 mm | Good | ±0.4 | Water-cooled |
| 3-7 | 500 | 180 | 0.57 mm | Good | ±0.4 | |
| 3-8 | 800 | 50 | 0.73 mm | | | Water-cooled; Tubular piece damage |
| 3-9 | 850 | 50 | 0.30 mm | V. good | ±0.4 | |
| 3-10 | 850 | 50 | 0.30 mm | V. good | ±0.4 | |
| 3-11 | 850 | 50 | 0.30 mm | V. good | ±0.4 | |
| 3-12 | 850 | 110 | 0.39 mm | Good | ±0.3 | |
| 3-13 | 850 | 120 | 0.32 mm | Good | ±0.3 | |
| 3-14 | 850 | 118 | 0.33 mm | Good | ±0.3 | |
| 3-15 | 850 | 200 | 0.23 mm | V. good | ±0.4 | |
| 3-16 | 850 | | | | | Tubular piece damage when attaching |
| 3-17 | 500 | 170 | 0.50 mm | Good | ±0.4 | |
| 3-18 | 500 | 167 | 0.48 mm | Good | ±0.4 | |
| 3-19 | 500 | 170 | 0.50 mm | Good | ±0.4 | |
| 3-20 | 500 | 105 | 0.05 mm | V. good | ±0.3 | |

Table VI

| Test conditions Heater substance: 3 (Aluminum nitride) | | | | | | |
|---|---|---|---|---|---|---|
| Sample | Tubular piece | | | Chamber subst. | Inter-piece separation at normal temperature | |
| | Substance | Fixing means | Length (mm) | | Heater end (L1) | Chamber end (L2) |
| 3-21 | Mullite | Glass | 100 | Ni | 300 | 300 |
| 3-22 | Mullite | Glass | 100 | Ni | 300 | 300 |
| 3-23 | Mullite | Screws | 100 | Ni | 300 | 300 |
| 3-24 | Mullite | Snugging | 100 | Ni | 300 | 300 |
| 3-25 | AlN | Glass | 100 | Ni | 300 | 300 |
| 3-26 | AlN | Glass | 150 | Ni | 300 | 300 |

Table VI (continued)

| Test conditions Heater substance: 3 (Aluminum nitride) | | | | | | |
|---|---|---|---|---|---|---|
| Sample | Tubular piece | | | Chamber subst. | Inter-piece separation at normal temperature | |
| | Substance | Fixing means | Length (mm) | | Heater end (L1) | Chamber end (L2) |
| 3-27 | AlN | Screws | 150 | Ni | 300 | 300 |
| 3-28 | AlN | Screws | 150 | Ni | 299.5 | 300 |
| 3-29 | AlN | Screws | 150 | Ni | 300 | 300.5 |
| 3-30 | AlN | Unitary type | 150 | Ni | 300 | 300.5 |
| 3-31 | $Si_3N_4$ | Glass | 150 | Ni | 300 | 300 |
| 3-32 | $Si_3N_4$ | Glass | 150 | Ni | 299.7 | 300 |
| 3-33 | $Si_3N_4$ | Glass | 150 | Ni | 300 | 300.3 |
| 3-34 | $Al_2O_3$ | Glass | 150 | Ni | 300 | 300 |
| 3-35 | SiC | Glass | 150 | Ni | 300 | 300 |
| 3-36 | W | Brazing material | 150 | Ni | 300 | 300 |
| 3-37 | Mo | Brazing material | 150 | Ni | 300 | 300 |
| 3-38 | Stainless steel | Screws | 150 | Ni | 300 | 300 |
| 3-39 | Stainless steel | Snugging | 150 | Ni | 300 | 300 |

Table VII

| Test results Heater substance: 3 (Aluminum nitride) | | | | | | |
|---|---|---|---|---|---|---|
| Sample | Use temp. (°C) | | Inter-piece separation discrepancy when heated | Gastightness | Temp. uniformity (%) | Notes |
| | Heater | Chamber | | | | |
| 3-21 | 500 | 95 | 0.30 mm | V good | ±0.2 | |
| 3-22 | 850 | 150 | 0.56 mm | Good | ±0.2 | |
| 3-23 | 850 | 145 | 0.58 mm | Good | ±0.2 | |
| 3-24 | 850 | 145 | 0.58 mm | Good | ±0.2 | |
| 3-25 | 850 | — | | | | O-ring damage |
| 3-26 | 500 | 180 | 0.03 mm | V. good | ±0.4 | |
| 3-27 | 800 | 50 | 0.88 mm | | | Water-cooled; Tubular piece damage |
| 3-28 | 850 | 50 | 0.45 mm | Good | ±0.4 | Water-cooled |
| 3-29 | 850 | 50 | 0.45 mm | Good | ±0.4 | Water-cooled |
| 3-30 | 850 | 50 | 0.45 mm | Good | ±0.4 | Water-cooled |

Table VII   (continued)

| Sample | Use temp. (°C) | | Inter-piece separation discrepancy when heated | Gastightness | Temp. uniformity (%) | Notes |
|---|---|---|---|---|---|---|
| | Heater | Chamber | | | | |
| 3-31 | 850 | 110 | 0.72 mm | | | Tubular piece damage |
| 3-32 | 850 | 110 | 0.42 mm | Good | ±0.4 | |
| 3-33 | 850 | 110 | 0.42 mm | Good | ±0.4 | |
| 3-34 | 850 | 120 | 0.68 mm | Good | ±0.3 | |
| 3-35 | 850 | 200 | 0.37 mm | Good | ±0.4 | |
| 3-36 | 500 | 170 | 0.01 mm | V good | ±0.4 | |
| 3-37 | 500 | 170 | 0.01 mm | V. good | ±0.4 | |
| 3-38 | 500 | 105 | 0.27 mm | V. good | ±0.3 | |
| 3-39 | 500 | 105 | 0.27 mm | V. good | ±0.3 | |

Test results
Heater substance: 3 (Aluminum nitride)

Table VIII

Test conditions
Heater substance: 3 (Aluminum nitride)

| Sample | Tubular piece | | | Chamber subst. | Inter-piece separation at normal temperature | |
|---|---|---|---|---|---|---|
| | Substance | Fixing means | Length (mm) | | Heater end (L1) | Chamber end (L2) |
| 3-40 | Mullite | Glass | 100 | Stainless steel | 300 | 300 |
| 3-41 | Mullite | Glass | 100 | Stainless steel | 300 | 300 |
| 3-42 | Mullite | Glass | 100 | Stainless steel | 299.5 | 300 |
| 3-43 | Mullite | Glass | 100 | Stainless steel | 300 | 300.3 |
| 3-44 | AlN | Glass | 100 | Stainless steel | 300 | 300 |
| 3-45 | AlN | Glass | 150 | Stainless steel | 300 | 300 |
| 3-46 | AlN | Screws | 150 | Stainless steel | 300 | 300 |
| 3-47 | AlN | Screws | 150 | Stainless steel | 299.5 | 300 |
| 3-48 | AlN | Unitary type | 150 | Stainless steel | 300 | 300 |
| 3-49 | AlN | Screws | 150 | Stainless steel | 300 | 300.5 |
| 3-50 | $Si_3N_4$ | Glass | 150 | Stainless steel | 300 | 300 |
| 3-51 | $Al_2O_3$ | Glass | 150 | Stainless steel | 300 | 300 |
| 3-52 | $Al_2O_3$ | Glass | 150 | Stainless steel | 299.5 | 300 |
| 3-53 | $Al_2O_3$ | Glass | 150 | Stainless steel | 300 | 300.5 |
| 3-54 | $Al_2O_3$ | Snugging | 150 | Stainless steel | 300 | 300.5 |
| 3-55 | SiC | Glass | 150 | Stainless steel | 300 | 300 |

Table VIII   (continued)

| Test conditions<br>Heater substance: 3 (Aluminum nitride) | | | | | | |
|---|---|---|---|---|---|---|
| Sample | Tubular piece | | | Chamber subst. | Inter-piece separation at normal temperature | |
| | Substance | Fixing means | Length (mm) | | Heater end (L1) | Chamber end (L2) |
| 3-56 | Ni | Brazing material | 150 | Stainless steel | 300 | 300 |
| 3-57 | W | Brazing material | 150 | Stainless steel | 300 | 300 |
| 3-58 | Mo | Brazing material | 150 | Stainless steel | 300 | 300 |
| 3-59 | Stainless steel | Screws | 150 | Stainless steel | 300 | 300 |

Table IX

| Test results<br>Heater substance: 3 (Aluminum nitride) | | | | | | |
|---|---|---|---|---|---|---|
| Sample | Use temp. (°C) | | Inter-piece separation discrepancy when heated | Gastightness | Temp. uniformity (%) | Notes |
| | Heater | Chamber | | | | |
| 3-40 | 500 | 95 | 0.45 mm | Good | ±0.2 | |
| 3-41 | 850 | 150 | 0.79 mm | | | Tubular piece damage |
| 3-42 | 850 | 150 | 0.29 mm | V. good | ±0.2 | |
| 3-43 | 850 | 150 | 0.49 mm | Good | ±0.2 | |
| 3-44 | 850 | — | | | | O-ring damage |
| 3-45 | 500 | 180 | 0.25 mm | V. good | ±0.4 | |
| 3-46 | 800 | 50 | 0.96 mm | | | Water-cooled; Tubular piece damage |
| 3-47 | 850 | 50 | 0.53 mm | Good | ±0.4 | Water-cooled |
| 3-48 | 850 | 50 | 1.03 mm | | | Water-cooled; Tubular piece damage |
| 3-49 | 850 | 50 | 0.53 mm | Good | ±0.4 | Water-cooled |
| 3-50 | 850 | 110 | 0.89 mm | | | Tubular piece damage |
| 3-51 | 850 | 120 | 0.86 mm | | | Tubular piece damage |
| 3-52 | 850 | 120 | 0.36 mm | Good | ±0.4 | |
| 3-53 | 850 | 120 | 0.36 mm | Good | ±0.4 | |
| 3-54 | 850 | 118 | 0.37 mm | Good | ±0.4 | |

Table IX   (continued)

| Test results Heater substance: 3 (Aluminum nitride) | | | | | |
|---|---|---|---|---|---|
| Sample | Use temp. (°C) | | Inter-piece separation discrepancy when heated | Gastightness | Temp. uniformity (%) | Notes |
| | Heater | Chamber | | | | |
| 3-55 | 850 | 200 | 0.67 mm | Good | ±0.4 | |
| 3-56 | 850 | | | | | Tubular piece damage when attaching |
| 3-57 | 500 | 170 | 0.27 mm | V. good | ±0.4 | |
| 3-58 | 500 | 170 | 0.27 mm | V good | ±0.4 | |
| 3-59 | 500 | 105 | 0.43 mm | Good | ±0.3 | |

Table X

| Test conditions Heater substance: 3 (Aluminum nitride) | | | | | | |
|---|---|---|---|---|---|---|
| Sample | Tubular piece | | | Chamber subst. | Inter-piece separation at normal temperature | |
| | Substance | Fixing means | Length (mm) | | Heater end (L1) | Chamber end (L2) |
| 3-60 | Mullite | Glass | 100 | $Al_2O_3$ | 300 | 300 |
| 3-61 | Mullite | Glass | 100 | $Al_2O_3$ | 300 | 300 |
| 3-62 | Mullite | Glass | 100 | $Al_2O_3$ | 299.5 | 300 |
| 3-63 | Mullite | Glass | 100 | $Al_2O_3$ | 300 | 300.3 |
| 3-64 | Mullite | Snugging | 100 | $Al_2O_3$ | 300 | 300.3 |
| 3-65 | AlN | Glass | 100 | $Al_2O_3$ | 300 | 300 |
| 3-66 | AlN | Unitary type | 150 | $Al_2O_3$ | 300 | 300 |
| 3-67 | AlN | Glass | 150 | $Al_2O_3$ | 300 | 300 |
| 3-68 | AlN | Screws | 150 | $Al_2O_3$ | 300 | 300 |
| 3-69 | AlN | Screws | 150 | $Al_2O_3$ | 299.5 | 300 |
| 3-70 | AlN | Screws | 150 | $Al_2O_3$ | 300 | 300.5 |
| 3-71 | $Si_3N_4$ | Glass | 150 | $Al_2O_3$ | 300 | 300 |
| 3-72 | $Al_2O_3$ | Glass | 150 | $Al_2O_3$ | 300 | 300 |
| 3-73 | $Al_2O_3$ | Glass | 150 | $Al_2O_3$ | 299.5 | 300 |
| 3-74 | $Al_2O_3$ | Glass | 150 | $Al_2O_3$ | 300 | 300.5 |
| 3-75 | SiC | Glass | 150 | $Al_2O_3$ | 300 | 300 |
| 3-76 | Ni | Brazing material | 150 | $Al_2O_3$ | 300 | 300 |
| 3-77 | W | Brazing material | 150 | $Al_2O_3$ | 300 | 300 |

Table X (continued)

| Test conditions Heater substance: 3 (Aluminum nitride) | | | | | | |
|---|---|---|---|---|---|---|
| Sample | Tubular piece | | | Chamber subst. | Inter-piece separation at normal temperature | |
| | Substance | Fixing means | Length (mm) | | Heater end (L1) | Chamber end (L2) |
| 3-78 | Mo | Brazing material | 150 | $Al_2O_3$ | 300 | 300 |
| 3-79 | Stainless steel | Screws | 150 | $Al_2O_3$ | 300 | 300 |

Table XI

| Test results Heater substance: 3 (Aluminum nitride) | | | | | | |
|---|---|---|---|---|---|---|
| Sample | Use temp. (°C) | | Inter-piece separation discrepancy when heated | Gastightness | Temp. uniformity (%) | Notes |
| | Heater | Chamber | | | | |
| 3-60 | 500 | 100 | 0.44 mm | Good | ±0.2 | |
| 3-61 | 850 | 155 | 0.78 mm | | | Tubular piece damage |
| 3-62 | 850 | 155 | 0.28 mm | V. good | ±0.2 | |
| 3-63 | 850 | 155 | 0.48 mm | Good | ±0.2 | |
| 3-64 | 850 | 152 | 0.49 mm | Good | ±0.2 | |
| 3-65 | 850 | — | | | | O-ring damage |
| 3-66 | 800 | 195 | 0.62 mm | Good | ±0.4 | |
| 3-67 | 500 | 190 | 0.23 mm | V. good | ±0.4 | |
| 3-68 | 800 | 50 | 0.96 mm | | | Water-cooled; Tubular piece damage |
| 3-69 | 850 | 50 | 0.53 mm | Good | ±0.4 | Water-cooled |
| 3-70 | 850 | 50 | 0.53 mm | Good | ±0.4 | Water-cooled |
| 3-71 | 850 | 115 | 0.88 mm | | | Tubular piece damage |
| 3-72 | 850 | 125 | 0.85 mm | | | Tubular piece damage |
| 3-73 | 850 | 125 | 0.35 mm | Good | ±0.4 | |
| 3-74 | 850 | 125 | 0.35 mm | Good | ±0.4 | |
| 3-75 | 850 | 210 | 0.66 mm | Good | ±0.4 | |
| 3-76 | 850 | | | | | Tubular piece damage when attaching |
| 3-77 | 500 | 180 | 0.25 mm | V good | ±0.4 | |

Table XI   (continued)

| Test results Heater substance: 3 (Aluminum nitride) | | | | | |
|---|---|---|---|---|---|
| Sample | Use temp. (°C) | | Inter-piece separation discrepancy when heated | Gastightness | Temp. uniformity (%) | Notes |
| | Heater | Chamber | | | | |
| 3-78 | 500 | 180 | 0.25 mm | V. good | ±0.4 | |
| 3-79 | 500 | 110 | 0.42 mm | Good | ±0.3 | |

Table XII

| Test conditions Heater substance: 8 (Silicon carbide) | | | | | | |
|---|---|---|---|---|---|---|
| Sample | Tubular piece | | | Chamber subst. | Inter-piece separation at normal temperature | |
| | Substance | Fixing means | Length (mm) | | Heater end (L1) | Chamber end (L2) |
| 8-1 | Mullite | Glass | 100 | Al | 300 | 300 |
| 8-2 | Mullite | Glass | 100 | Al | 300 | 300 |
| 8-3 | Mullite | Screws | 100 | Al | 300 | 300 |
| 8-4 | Mullite | Snugging | 100 | Al | 300 | 300 |
| 8-5 | AlN | Glass | 100 | Al | 300 | 300 |
| 8-6 | AlN | Glass | 150 | Al | 300 | 300 |
| 8-7 | AlN | Screws | 150 | Al | 300 | 300 |
| 8-8 | $Si_3N_4$ | Glass | 150 | Al | 300 | 300 |
| 8-9 | $Al_2O_3$ | Glass | 150 | Al | 300 | 300 |
| 8-10 | SiC | Glass | 150 | Al | 300 | 300 |
| 8-11 | SiC | Unitary type | 150 | Al | 300 | 300 |
| 8-12 | Ni | Brazing material | 150 | Al | 300 | 300 |
| 8-13 | W | Brazing material | 150 | Al | 300 | 300 |
| 8-14 | Mo | Brazing material | 150 | Al | 300 | 300 |
| 8-15 | Stainless steel | Screws | 150 | Al | 300 | 300 |

## EP 1 544 898 A1

Table XIII

| Test results |
| Heater substance: 8 (Silicon carbide) |

| Sample | Use temp. (°C) | | Inter-piece separation discrepancy when heated | Gastightness | Temp. uniformity (%) | Notes |
|--------|--------|---------|---|---|---|---|
| | Heater | Chamber | | | | |
| 8-1 | 500 | 95 | 0.09 mm | V. good | ±0.2 | |
| 8-2 | 850 | 148 | 0.05 mm | V. good | ±0.2 | |
| 8-3 | 850 | 145 | 0.03 mm | V. good | ±0.2 | |
| 8-4 | 850 | 142 | 0.01 mm | V. good | ±0.2 | |
| 8-5 | 850 | — | | | | O-ring damage |
| 8-6 | 500 | 182 | 0.69 mm | Good | ±0.4 | |
| 8-7 | 850 | 50 | 0.62 mm | Good | | Water-cooled |
| 8-8 | 850 | 111 | 0.20 mm | V. good | ±0.3 | |
| 8-9 | 850 | 120 | 0.14 mm | V. good | ±0.3 | |
| 8-10 | 850 | 200 | 0.41 mm | Good | ±0.4 | |
| 8-11 | 850 | 205 | 0.45 mm | Good | ±0.4 | |
| 8-12 | 850 | | | | | Tubular piece damage when attaching |
| 8-13 | 500 | 170 | 0.60 mm | Good | ±0.4 | |
| 8-14 | 500 | 170 | 0.60 mm | Good | ±0.4 | |
| 8-15 | 500 | 105 | 0.15 mm | V. good | ±0.3 | |

Table XIV

| Test conditions |
| Heater substance: 8 (Silicon carbide) |

| Sample | Tubular piece | | | Chamber subst. | Inter-piece separation at normal temperature | |
|--------|--------|--------------|-------------|------|--------------|------------------|
| | Substance | Fixing means | Length (mm) | | Heater end (L1) | Chamber end (L2) |
| 8-16 | Mullite | Glass | 100 | Ni | 300 | 300 |
| 8-17 | Mullite | Glass | 100 | Ni | 300 | 300 |
| 8-18 | Mullite | Screws | 100 | Ni | 300 | 300 |
| 8-19 | AIN | Glass | 100 | Ni | 300 | 300 |
| 8-20 | AIN | Glass | 150 | Ni | 300 | 300 |
| 8-21 | AIN | Screws | 150 | Ni | 300 | 300 |
| 8-22 | AIN | Screws | 150 | Ni | 299.5 | 300 |
| 8-23 | AIN | Screws | 150 | Ni | 300 | 300.4 |
| 8-24 | $Si_3N_4$ | Glass | 150 | Ni | 300 | 300 |

**EP 1 544 898 A1**

Table XIV   (continued)

| Test conditions Heater substance: 8 (Silicon carbide) | | | | | | |
|---|---|---|---|---|---|---|
| Sample | Tubular piece | | | Chamber subst. | Inter-piece separation at normal temperature | |
| | Substance | Fixing means | Length (mm) | | Heater end (L1) | Chamber end (L2) |
| 8-25 | $Al_2O_3$ | Glass | 150 | Ni | 300 | 300 |
| 8-26 | SiC | Glass | 150 | Ni | 300 | 300 |
| 8-27 | SiC | Unitary type | 150 | Ni | 300 | 300 |
| 8-28 | W | Brazing material | 150 | Ni | 300 | 300 |
| 8-29 | Mo | Brazing material | 150 | Ni | 300 | 300 |
| 8-30 | Stainless steel | Screws | 150 | Ni | 300 | 300 |

Table XV

| Test results Heater substance: 8 (Silicon carbide) | | | | | | |
|---|---|---|---|---|---|---|
| Sample | Use temp. (°C) | | Inter-piece separation discrepancy when heated | Gastightness | Temp. uniformity (%) | Notes |
| | Heater | Chamber | | | | |
| 8-16 | 500 | 95 | 0.20 mm | V. good | ±0.2 | |
| 8-17 | 850 | 152 | 0.38 mm | Good | ±0.2 | |
| 8-18 | 850 | 145 | 0.40 mm | Good | ±0.2 | |
| 8-19 | 850 | — | | | | O-ring damage |
| 8-20 | 500 | 180 | 0.13 mm | V. good | ±0.4 | |
| 8-21 | 800 | 50 | 0.72 mm | | | Water-cooled; Tubular piece damage |
| 8-22 | 850 | 50 | 0.27 mm | V. good | ±0.4 | |
| 8-23 | 850 | 50 | 0.37 mm | Good | ±0.4 | |
| 8-24 | 850 | 111 | 0.54 mm | Good | ±0.4 | |
| 8-25 | 850 | 120 | 0.50 mm | Good | ±0.3 | |
| 8-26 | 850 | 203 | 0.13 mm | V. good | ±0.4 | |
| 8-27 | 850 | 208 | 0. 16 mm | V good | ±0.4 | |
| 8-28 | 500 | 170 | 0.09 mm | V. good | ±0.4 | |
| 8-29 | 500 | 170 | 0.09 mm | V good | ±0.4 | |
| 8-30 | 500 | 105 | 0.16 mm | V good | ±0.3 | |

Table XVI

| Test conditions | | | | | | |
|---|---|---|---|---|---|---|
| Heater substance: 8 (Silicon carbide) | | | | | | |
| Sample | Tubular piece | | | Chamber subst. | Inter-piece separation at normal temperature | |
| | Substance | Fixing means | Length (mm) | | Heater end (L1) | Chamber end (L2) |
| 8-31 | Mullite | Glass | 100 | Stainless steel | 300 | 300 |
| 8-32 | Mullite | Glass | 100 | Stainless steel | 300 | 300 |
| 8-33 | Mullite | Screws | 100 | Stainless steel | 300 | 300 |
| 8-34 | Mullite | Snugging | 100 | Stainless steel | 300 | 300 |
| 8-35 | AlN | Glass | 100 | Stainless steel | 300 | 300 |
| 8-36 | AlN | Glass | 150 | Stainless steel | 300 | 300 |
| 8-37 | AlN | Screws | 150 | Stainless steel | 300 | 300 |
| 8-38 | AlN | Screws | 150 | Stainless steel | 299.5 | 300 |
| 8-39 | AlN | Screws | 150 | Stainless steel | 300 | 300.4 |
| 8-40 | $Si_3N_4$ | Glass | 150 | Stainless steel | 300 | 300 |
| 8-41 | $Al_2O_3$ | Glass | 150 | Stainless steel | 300 | 300 |
| 8-42 | SiC | Glass | 150 | Stainless steel | 300 | 300 |
| 8-43 | Ni | Brazing material | 150 | Stainless steel | 300 | 300 |
| 8-44 | W | Brazing material | 150 | Stainless steel | 300 | 300 |
| 8-45 | Mo | Brazing material | 150 | Stainless steel | 300 | 300 |
| 8-46 | Stainless steel | Screws | 150 | Stainless steel | 300 | 300 |

Table XVII

| Test results | | | | | | |
|---|---|---|---|---|---|---|
| Heater substance: 8 (Silicon carbide) | | | | | | |
| Sample | Use temp. (°C) | | Inter-piece separation discrepancy when heated | Gastightness | Temp. uniformity (%) | Notes |
| | Heater | Chamber | | | | |
| 8-31 | 500 | 95 | 0.34 mm | Good | ±0.2 | |
| 8-32 | 850 | 153 | 0.61 mm | Good | ±0.2 | |
| 8-33 | 850 | 153 | 0.61 mm | Good | ±0.2 | |
| 8-34 | 850 | 152 | 0.61 mm | Good | ±0.2 | |
| 8-35 | 850 | — | | | | O-ring damage |
| 8-36 | 500 | 180 | 0.14 mm | V good | ±0.4 | |

Table XVII (continued)

| Test results<br>Heater substance: 8 (Silicon carbide) | | | | | |
| --- | --- | --- | --- | --- | --- |
| Sample | Use temp. (°C) | | Inter-piece separation discrepancy when heated | Gastightness | Temp. uniformity (%) | Notes |
| | Heater | Chamber | | | | |
| 8-37 | 800 | 50 | 0.79 mm | | | Water-cooled; Tubular piece damage |
| 8-38 | 850 | 50 | 0.35 mm | Good | ±0.4 | |
| 8-39 | 850 | 50 | 0.45 mm | Good | ±0.4 | |
| 8-40 | 850 | 110 | 0.71 mm | | | Tubular piece damage |
| 8-41 | 850 | 123 | 0.68 mm | Good | ±0.4 | |
| 8-42 | 850 | 202 | 0.49 mm | Good | ±0.4 | |
| 8-43 | 850 | | | | | Tubular piece damage when attaching |
| 8-44 | 500 | 171 | 0.16 mm | V good | ±0.4 | |
| 8-45 | 500 | 171 | 0.16 mm | V. good | ±0.4 | |
| 8-46 | 500 | 107 | 0.32 mm | Good | ±0.3 | |

Table XVIII

| Test conditions<br>Heater substance: 8 (Silicon carbide) | | | | | | |
| --- | --- | --- | --- | --- | --- | --- |
| Sample | Tubular piece | | | Chamber subst. | Inter-piece separation at normal temperature | |
| | Substance | Fixing means | Length (mm) | | Heater end (L1) | Chamber end (L2) |
| 8-47 | Mullite | Glass | 100 | $Al_2O_3$ | 300 | 300 |
| 8-48 | Mullite | Glass | 100 | $Al_2O_3$ | 300 | 300 |
| 8-49 | AlN | Glass | 100 | $Al_2O_3$ | 300 | 300 |
| 8-50 | AlN | Glass | 150 | $Al_2O_3$ | 300 | 300 |
| 8-51 | AlN | Screws | 150 | $Al_2O_3$ | 300 | 300 |
| 8-52 | AlN | Screws | 150 | $Al_2O_3$ | 299.5 | 300 |
| 8-53 | AlN | Screws | 150 | $Al_2O_3$ | 300 | 300.4 |
| 8-54 | $Si_3N_4$ | Glass | 150 | $Al_2O_3$ | 300 | 300 |
| 8-55 | $Al_2O_3$ | Glass | 150 | $Al_2O_3$ | 300 | 300 |
| 8-56 | SiC | Unitary type | 150 | $Al_2O_3$ | 300 | 300 |
| 8-57 | SiC | Glass | 150 | $Al_2O_3$ | 300 | 300 |
| 8-58 | Ni | Brazing material | 150 | $Al_2O_3$ | 300 | 300 |

Table XVIII   (continued)

| Test conditions Heater substance: 8 (Silicon carbide) | | | | | | |
|---|---|---|---|---|---|---|
| Sample | Tubular piece | | | Chamber subst. | Inter-piece separation at normal temperature | |
| | Substance | Fixing means | Length (mm) | | Heater end (L1) | Chamber end (L2) |
| 8-59 | W | Brazing material | 150 | $Al_2O_3$ | 300 | 300 |
| 8-60 | Mo | Brazing material | 150 | $Al_2O_3$ | 300 | 300 |
| 8-61 | Stainless steel | Screws | 150 | $Al_2O_3$ | 300 | 300 |

Table XIX

| Test results Heater substance: 8 (Silicon carbide) | | | | | | |
|---|---|---|---|---|---|---|
| Sample | Use temp. (°C) | | Inter-piece separation discrepancy when heated | Gastightness | Temp. uniformity (%) | Notes |
| | Heater | Chamber | | | | |
| 8-47 | 500 | 98 | 0.34 mm | Good | ±0.2 | |
| 8-48 | 850 | 158 | 0.60 mm | Good | ±0.2 | |
| 8-49 | 850 | — | | | | O-ring damage |
| 8-50 | 500 | 189 | 0.13 mm | V good | ±0.4 | |
| 8-51 | 800 | 50 | 0.79 mm | | | Water-cooled; Tubular piece damage |
| 8-52 | 850 | 50 | 0.35 mm | Good | ±0.4 | |
| 8-53 | 850 | 50 | 0.45 mm | Good | ±0.4 | |
| 8-54 | 850 | 111 | 0.71 mm | | | Tubular piece damage |
| 8-55 | 850 | 128 | 0.67 mm | Good | ±0.4 | |
| 8-56 | 850 | 215 | 0.47 mm | Good | ±0.4 | |
| 8-57 | 850 | 213 | 0.47 mm | Good | ±0.4 | |
| 8-58 | 850 | | | | | Tubular piece damage when attaching |
| 8-59 | 500 | 179 | 0.15 mm | V good | ±0.4 | |
| 8-60 | 500 | 180 | 0.15 mm | V good | ±0.4 | |
| 8-61 | 500 | 111 | 0.31 mm | Good | ±0.3 | |

Table XX

| Test conditions Heater substance: 9 (Alumina) | | | | | | |
|---|---|---|---|---|---|---|
| Sample | Tubular piece | | | Chamber subst. | Inter-piece separation at normal temperature | |
| | Substance | Fixing means | Length (mm) | | Heater end (L1) | Chamber end (L2) |
| 9-1 | Mullite | Glass | 100 | Al | 300 | 300 |
| 9-2 | Mullite | Glass | 100 | Al | 300 | 300 |
| 9-3 | Mullite | Snugging | 100 | Al | 300 | 300 |
| 9-4 | Mullite | Screws | 100 | Al | 300 | 300 |
| 9-5 | AlN | Glass | 100 | Al | 300 | 300 |
| 9-6 | AlN | Glass | 150 | Al | 300 | 300 |
| 9-7 | AlN | Screws | 150 | Al | 300 | 300 |
| 9-8 | AlN | Screws | 150 | Al | 299.5 | 300 |
| 9-9 | $Si_3N_4$ | Glass | 150 | Al | 300 | 300 |
| 9-10 | $Al_2O_3$ | Glass | 150 | Al | 300 | 300 |
| 9-11 | SiC | Glass | 150 | Al | 300 | 300 |
| 9-12 | Ni | Brazing material | 150 | Al | 300 | 300 |
| 9-13 | W | Brazing material | 150 | Al | 300 | 300 |
| 9-14 | Mo | Brazing material | 150 | Al | 300 | 300 |
| 9-15 | Stainless steel | Screws | 150 | Al | 300 | 300 |

Table XXI

| Test results Heater substance: 9 (Alumina) | | | | | | |
|---|---|---|---|---|---|---|
| Sample | Use temp. (°C) | | Inter-piece separation discrepancy when heated | Gastightness | Temp. uniformity (%) | Notes |
| | Heater | Chamber | | | | |
| 9-1 | 500 | 93 | 0.53 mm | Good | ±0.6 | |
| 9-2 | 850 | 148 | 0.97 mm | | | Tubular piece damage |
| 9-3 | 500 | 92 | 0.54 mm | Good | ±0.6 | |
| 9-4 | 850 | 142 | 1.01 mm | | | Tubular piece damage |
| 9-5 | 850 | — | | | | O-ring damage |
| 9-6 | 500 | 181 | 0.08 mm | V. good | ±1.0 | |

Table XXI   (continued)

| Sample | Use temp. (°C) | | Inter-piece separation discrepancy when heated | Gastightness | Temp. uniformity (%) | Notes |
|---|---|---|---|---|---|---|
| | Heater | Chamber | | | | |
| 9-7 | 800 | 49 | 1.53 mm | | | Water-cooled; Tubular piece damage |
| 9-8 | 850 | 51 | 1.13 mm | | | Tubular piece damage |
| 9-9 | 850 | 111 | 1.22 mm | | | Tubular piece damage |
| 9-10 | 850 | 118 | 1.17 mm | | | Tubular piece damage |
| 9-11 | 850 | 202 | 0.60 mm | Good | ±1.0 | |
| 9-12 | 850 | | | | | Tubular piece damage when attaching |
| 9-13 | 500 | 175 | 0.04 mm | V. good | ±1.0 | |
| 9-14 | 500 | 174 | 0.03 mm | V. good | ±1.0 | |
| 9-15 | 500 | 102 | 0.47 mm | Good | ±0.8 | |

Test results
Heater substance: 9 (Alumina)

Table XXII

| Sample | Tubular piece | | | Chamber subst. | Inter-piece separation at normal temperature | |
|---|---|---|---|---|---|---|
| | Substance | Fixing means | Length (mm) | | Heater end (L1) | Chamber end (L2) |
| 9-16 | Mullite | Glass | 100 | Ni | 300 | 300 |
| 9-17 | Mullite | Glass | 100 | Ni | 300 | 300 |
| 9-18 | Mullite | Screws | 100 | Ni | 300 | 300 |
| 9-19 | AlN | Glass | 100 | Ni | 300 | 300 |
| 9-20 | AlN | Glass | 150 | Ni | 300 | 300 |
| 9-21 | AlN | Screws | 150 | Ni | 300 | 300 |
| 9-22 | AlN | Screws | 150 | Ni | 299.5 | 300 |
| 9-23 | $Si_3N_4$ | Glass | 150 | Ni | 300 | 300 |
| 9-24 | $Si_3N_4$ | Glass | 150 | Ni | 299.7 | 300 |
| 9-25 | $Al_2O_3$ | Glass | 150 | Ni | 300 | 300 |
| 9-26 | SiC | Glass | 150 | Ni | 300 | 300 |

Test conditions
Heater substance: 9 (Alumina)

Table XXII   (continued)

| Test conditions Heater substance: 9 (Alumina) | | | | | | |
|---|---|---|---|---|---|---|
| Sample | Tubular piece | | | Chamber subst. | Inter-piece separation at normal temperature | |
| | Substance | Fixing means | Length (mm) | | Heater end (L1) | Chamber end (L2) |
| 9-27 | W | Brazing material | 150 | Ni | 300 | 300 |
| 9-28 | Mo | Brazing material | 150 | Ni | 300 | 300 |
| 9-29 | Stainless steel | Screws | 150 | Ni | 300 | 300 |

Table XXIII

| Test results Heater substance: 9 (Alumina) | | | | | | |
|---|---|---|---|---|---|---|
| Sample | Use temp. (°C) | | Inter-piece separation discrepancy when heated | Gastightness | Temp. uniformity (%) | Notes |
| | Heater | Chamber | | | | |
| 9-16 | 500 | 96 | 0.80 mm | | | Tubular piece damage |
| 9-17 | 850 | 152 | 1.40 mm | | | Tubular piece damage |
| 9-18 | 850 | 144 | 1.43 mm | | | Tubular piece damage |
| 9-19 | 850 | — | | | | O-ring damage |
| 9-20 | 500 | 179 | 0.47 mm | Good | ±1.0 | |
| 9-21 | 800 | 50 | 1.68 mm | | | Water-cooled; Tubular piece damage |
| 9-22 | 850 | 51 | 1.29 mm | | | Water-cooled |
| 9-23 | 850 | 109 | 1.56 mm | | | Tubular piece damage |
| 9-24 | 850 | 109 | 1.26 mm | | | Tubular piece damage |
| 9-25 | 850 | 121 | 1.52 mm | | | Tubular piece damage |
| 9-26 | 850 | 202 | 1.20 mm | | | Tubular piece damage |
| 9-27 | 500 | 170 | 0.51 mm | Good | ±1.0 | |
| 9-28 | 500 | 170 | 0.51 mm | Good | ±1.0 | |
| 9-29 | 500 | 105 | 0.76 mm | | | Tubular piece damage |

Table XXIV

| Test conditions Heater substance: 9 (Alumina) | | | | | | |
|---|---|---|---|---|---|---|
| Sample | Tubular piece | | | Chamber subst. | Inter-piece separation at normal temperature | |
| | Substance | Fixing means | Length (mm) | | Heater end (L1) | Chamber end (L2) |
| 9-30 | Mullite | Glass | 100 | Stainless steel | 300 | 300 |
| 9-31 | Mullite | Glass | 100 | Stainless steel | 300 | 300 |
| 9-32 | Mullite | Glass | 100 | Stainless steel | 299.5 | 300 |
| 9-33 | AlN | Glass | 100 | Stainless steel | 300 | 300 |
| 9-34 | AlN | Glass | 150 | Stainless steel | 299.7 | 300 |
| 9-35 | AlN | Screws | 150 | Stainless steel | 300 | 300 |
| 9-36 | AlN | Screws | 150 | Stainless steel | 299.5 | 300 |
| 9-37 | $Si_3N_4$ | Glass | 150 | Stainless steel | 300 | 300 |
| 9-38 | $Al_2O_3$ | Glass | 150 | Stainless steel | 300 | 300 |
| 9-39 | $Al_2O_3$ | Glass | 150 | Stainless steel | 299.5 | 300 |
| 9-40 | $Al_2O_3$ | Snugging | 150 | Stainless steel | 299.5 | 300 |
| 9-41 | SiC | Glass | 150 | Stainless steel | 300 | 300 |
| 9-42 | Ni | Brazing material | 150 | Stainless steel | 300 | 300 |
| 9-43 | W | Brazing material | 150 | Stainless steel | 300 | 300 |
| 9-44 | Mo | Brazing material | 150 | Stainless steel | 300 | 300 |
| 9-45 | Stainless steel | Screws | 150 | Stainless steel | 300 | 300 |

Table XXV

| Test results Heater substance: 9 (Alumina) | | | | | | |
|---|---|---|---|---|---|---|
| Sample | Use temp. (°C) | | Inter-piece separation discrepancy when heated | Gastightness | Temp. uniformity (%) | Notes |
| | Heater | Chamber | | | | |
| 9-30 | 500 | 95 | 0.94 mm | | | Tubular piece damage |
| 9-31 | 850 | 150 | 1.63 mm | | | Tubular piece damage |
| 9-32 | 850 | 150 | 1.13 mm | | | Tubular piece damage |
| 9-33 | 850 | — | | | | O-ring damage |
| 9-34 | 500 | 180 | 0.44 mm | Good | ±1.0 | |

Table XXV   (continued)

| Test results Heater substance: 9 (Alumina) | | | | | | |
|---|---|---|---|---|---|---|
| Sample | Use temp. (°C) | | Inter-piece separation discrepancy when heated | Gastightness | Temp. uniformity (%) | Notes |
| | Heater | Chamber | | | | |
| 9-35 | 800 | 50 | 1.75 mm | | | Water-cooled; Tubular piece damage |
| 9-36 | 850 | 50 | 1.37 mm | | | Water-cooled |
| 9-37 | 850 | 110 | 1.73 mm | | | Tubular piece damage |
| 9-38 | 850 | 120 | 1.70 mm | | | Tubular piece damage |
| 9-39 | 850 | 120 | 1.20 mm | | | Tubular piece damage |
| 9-40 | 850 | 118 | 1.21 mm | | | Tubular piece damage |
| 9-41 | 850 | 200 | 1.51 mm | | | Tubular piece damage |
| 9-42 | 850 | | | | | Tubular piece damage when attaching |
| 9-43 | 500 | 170 | 0.77 mm | | | Tubular piece damage |
| 9-44 | 500 | 170 | 0.77 mm | | | Tubular piece damage |
| 9-45 | 500 | 105 | 0.92 mm | | | Tubular piece damage |

Table XXVI

| Test conditions Heater substance: 9 (Alumina) | | | | | | |
|---|---|---|---|---|---|---|
| Sample | Tubular piece | | | Chamber subst. | Inter-piece separation at normal temperature | |
| | Substance | Fixing means | Length (mm) | | Heater end (L1) | Chamber end (L2) |
| 9-46 | Mullite | Glass | 100 | $Al_2O_3$ | 300 | 300 |
| 9-47 | Mullite | Glass | 100 | $Al_2O_3$ | 300 | 300 |
| 9-48 | Mullite | Glass | 100 | $Al_2O_3$ | 299.5 | 300 |
| 9-49 | AIN | Glass | 100 | $Al_2O_3$ | 300 | 300 |
| 9-50 | AIN | Glass | 150 | $Al_2O_3$ | 300 | 300 |
| 9-51 | AIN | Glass | 150 | $Al_2O_3$ | 299.7 | 300 |

Table XXVI (continued)

| Test conditions Heater substance: 9 (Alumina) | | | | | | |
|---|---|---|---|---|---|---|
| Sample | Tubular piece | | | Chamber subst. | Inter-piece separation at normal temperature | |
| | Substance | Fixing means | Length (mm) | | Heater end (L1) | Chamber end (L2) |
| 9-52 | AlN | Screws | 150 | $Al_2O_3$ | 300 | 300 |
| 9-53 | AlN | Screws | 150 | $Al_2O_3$ | 299.5 | 300 |
| 9-54 | $Si_3N_4$ | Glass | 150 | $Al_2O_3$ | 300 | 300 |
| 9-55 | $Al_2O_3$ | Glass | 150 | $Al_2O_3$ | 300 | 300 |
| 9-56 | $Al_2O_3$ | Glass | 150 | $Al_2O_3$ | 299.5 | 300 |
| 9-57 | $Al_2O_3$ | Unitary type | 150 | $Al_2O_3$ | 299.5 | 300 |
| 9-58 | SiC | Glass | 150 | $Al_2O_3$ | 300 | 300 |
| 9-59 | Ni | Brazing material | 150 | $Al_2O_3$ | 300 | 300 |
| 9-60 | W | Brazing material | 150 | $Al_2O_3$ | 300 | 300 |
| 9-61 | Mo | Brazing material | 150 | $Al_2O_3$ | 300 | 300 |
| 9-62 | Stainless steel | Screws | 150 | $Al_2O_3$ | 300 | 300 |

Table XXVII

| Test results Heater substance: 9 (Alumina) | | | | | | |
|---|---|---|---|---|---|---|
| Sample | Use temp. (°C) | | Inter-piece separation discrepancy when heated | Gastightness | Temp. uniformity (%) | Notes |
| | Heater | Chamber | | | | |
| 9-46 | 500 | 98 | 0.94 mm | | | Tubular piece damage |
| 9-47 | 850 | 153 | 1.63 mm | | | Tubular piece damage |
| 9-48 | 850 | 153 | 1.13 mm | | | Tubular piece damage |
| 9-49 | 850 | — | | | | O-ring damage |
| 9-50 | 500 | 191 | 0.72 mm | | | Tubular piece damage |
| 9-51 | 500 | 191 | 0.42 mm | Good | ±1.0 | |
| 9-52 | 800 | 50 | 1.76 mm | | | Water-cooled; Tubular piece damage |
| 9-53 | 850 | 50 | 1.37 mm | | | Water-cooled |

Table XXVII (continued)

| Test results Heater substance: 9 (Alumina) | | | | | |
|---|---|---|---|---|---|
| Sample | Use temp. (°C) | | Inter-piece separation discrepancy when heated | Gastightness | Temp. uniformity (%) | Notes |
| | Heater | Chamber | | | | |
| 9-54 | 850 | 115 | 1.72 mm | | | Tubular piece damage |
| 9-55 | 850 | 124 | 1.70 mm | | | Tubular piece damage |
| 9-56 | 850 | 124 | 1.20 mm | | | Tubular piece damage |
| 9-57 | 500 | 98 | 0.44 mm | Good | ±0.9 | |
| 9-58 | 850 | 211 | 1.50 mm | | | Tubular piece damage |
| 9-59 | 850 | | | | | Tubular piece damage when attaching |
| 9-60 | 500 | 179 | 0.75 mm | | | Tubular piece damage |
| 9-61 | 500 | 178 | 0.75 mm | | | Tubular piece damage |
| 9-62 | 500 | 109 | 0.91 mm | | | Tubular piece damage |

Table XXVIII

| Test conditions Heater substance: 10 (Silicon nitride) | | | | | | |
|---|---|---|---|---|---|---|
| Sample | Tubular piece | | | Chamber subst. | Inter-piece separation at normal temperature | |
| | Substance | Fixing means | Length (mm) | | Heater end (L1) | Chamber end (L2) |
| 10-1 | Mullite | Glass | 100 | Al | 300 | 300 |
| 10-2 | Mullite | Glass | 100 | Al | 300 | 300 |
| 10-3 | Mullite | Screws | 100 | Al | 300 | 300 |
| 10-4 | Mullite | Screws | 120 | Al | 300 | 300 |
| 10-5 | Mullite | Snugging | 120 | Al | 300 | 300 |
| 10-6 | AIN | Glass | 100 | Al | 300 | 300 |
| 10-7 | AIN | Glass | 150 | Al | 300 | 300 |
| 10-8 | AIN | Screws | 150 | Al | 300 | 300 |
| 10-9 | AIN | Screws | 150 | Al | 300 | 300 |
| 10-10 | $Si_3N_4$ | Glass | 150 | Al | 300 | 300 |

Table XXVIII   (continued)

| Test conditions Heater substance: 10 (Silicon nitride) | | | | | | |
|---|---|---|---|---|---|---|
| Sample | Tubular piece | | | Chamber subst. | Inter-piece separation at normal temperature | |
| | Substance | Fixing means | Length (mm) | | Heater end (L1) | Chamber end (L2) |
| 10-11 | $Si_3N_4$ | Unitary type | 150 | Al | 300 | 300 |
| 10-12 | $Al_2O_3$ | Glass | 150 | Al | 300 | 300 |
| 10-13 | SiC | Glass | 150 | Al | 300 | 300 |
| 10-14 | Ni | Brazing material | 150 | Al | 300 | 300 |
| 10-15 | W | Brazing material | 150 | Al | 300 | 300 |
| 10-16 | Mo | Brazing material | 150 | Al | 300 | 300 |
| 10-17 | Stainless steel | Screws | 150 | Al | 300 | 300 |

Table XXIX

| Test results Heater substance: 10 (Silicon nitride) | | | | | | |
|---|---|---|---|---|---|---|
| Sample | Use temp. (°C) | | Inter-piece separation discrepancy when heated | Gastightness | Temp. uniformity (%) | Notes |
| | Heater | Chamber | | | | |
| 10-1 | 500 | 95 | 0.09 mm | V. good | ±0.6 | |
| 10-2 | 850 | 148 | 0.05 mm | V. good | ±0.6 | |
| 10-3 | 850 | 145 | 0.03 mm | V. good | ±0.6 | |
| 10-4 | 1100 | 185 | 0.02 mm | V good | ±0.6 | |
| 10-5 | 1100 | 184 | 0.02 mm | V. good | ±0.6 | |
| 10-6 | 850 | — | | | | O-ring damage |
| 10-7 | 500 | 182 | 0.69 mm | Good | ±1.0 | |
| 10-8 | 850 | 50 | 0.62 mm | Good | ±1.0 | Water-Water-cooled |
| 10-9 | 1100 | 50 | 0.91 mm | | | Water-cooled; Tubular piece damage |
| 10-10 | 850 | 111 | 0.20 mm | V. good | ±0.8 | |
| 10-11 | 850 | 113 | 0.19 mm | V good | ±0.8 | |
| 10-12 | 850 | 120 | 0.14 mm | V. good | ±0.8 | |
| 10-13 | 850 | 200 | 0.41 mm | Good | ±1.0 | |

Table XXIX   (continued)

| Test results Heater substance: 10 (Silicon nitride) | | | | | | |
|---|---|---|---|---|---|---|
| Sample | Use temp. (°C) | | Inter-piece separation discrepancy when heated | Gastightness | Temp. uniformity (%) | Notes |
| | Heater | Chamber | | | | |
| 10-14 | 850 | | | | | Tubular piece damage when attaching |
| 10-15 | 500 | 170 | 0.60 mm | Good | ±1.0 | |
| 10-16 | 500 | 170 | 0.60 mm | Good | ±1.0 | |
| 10-17 | 500 | 105 | 0.15 mm | V. good | ±0.8 | |

Table XXX

| Test conditions Heater substance: 10 (Silicon nitride) | | | | | | |
|---|---|---|---|---|---|---|
| Sample | Tubular piece | | | Chamber subst. | Inter-piece separation at normal temperature | |
| | Substance | Fixing means | Length (mm) | | Heater end (L1) | Chamber end (L2) |
| 10-18 | Mullite | Glass | 100 | Ni | 300 | 300 |
| 10-19 | Mullite | Glass | 100 | Ni | 300 | 300 |
| 10-20 | Mullite | Snugging | 100 | Ni | 300 | 300 |
| 10-21 | Mullite | Screws | 100 | Ni | 300 | 300 |
| 10-22 | AIN | Glass | 100 | Ni | 300 | 300 |
| 10-23 | AIN | Glass | 150 | Ni | 300 | 300 |
| 10-24 | AIN | Screws | 150 | Ni | 300 | 300 |
| 10-25 | AIN | Screws | 150 | Ni | 300 | 300.4 |
| 10-26 | $Si_3N_4$ | Glass | 150 | Ni | 300 | 300 |
| 10-27 | $Si_3N_4$ | Unitary type | 150 | Ni | 300 | 300 |
| 10-28 | $Al_2O_3$ | Glass | 150 | Ni | 300 | 300 |
| 10-29 | SiC | Glass | 150 | Ni | 300 | 300 |
| 10-30 | W | Brazing material | 150 | Ni | 300 | 300 |
| 10-31 | Mo | Brazing material | 150 | Ni | 300 | 300 |
| 10-32 | Stainless steel | Screws | 150 | Ni | 300 | 300 |

Table XXXI

| Test results | | | | | | |
|---|---|---|---|---|---|---|
| Heater substance: 10 (Silicon nitride) | | | | | | |
| Sample | Use temp. (°C) | | Inter-piece separation discrepancy when heated | Gastightness | Temp. uniformity (%) | Notes |
| | Heater | Chamber | | | | |
| 10-18 | 500 | 95 | 0.20 mm | V. good | ±0.6 | |
| 10-19 | 850 | 152 | 0.38 mm | Good | ±0.6 | |
| 10-20 | 850 | 151 | 0.38 mm | Good | ±0.6 | |
| 10-21 | 850 | 145 | 0.40 mm | Good | ±0.6 | |
| 10-22 | 850 | — | | | | O-ring damage |
| 10-23 | 500 | 180 | 0.13 mm | V good | ±1.0 | |
| 10-24 | 850 | 50 | 0.77 mm | | | Water-cooled; Tubular piece damage |
| 10-25 | 850 | 50 | 0.37 mm | Good | ±1.0 | |
| 10-26 | 850 | 111 | 0.54 mm | Good | ±1.0 | |
| 10-27 | 850 | 114 | 0.52 mm | Good | ±1.0 | |
| 10-28 | 850 | 120 | 0.50 mm | Good | ±0.8 | |
| 10-29 | 850 | 203 | 0.18 mm | V. good | ±1.0 | |
| 10-30 | 500 | 170 | 0.09 mm | V. good | ±1.0 | |
| 10-31 | 500 | 170 | 0.09 mm | V. good | ±1.0 | |
| 10-32 | 500 | 105 | 0.16 mm | V good | ±0.8 | |

Table XXXII

| Test conditions | | | | | | |
|---|---|---|---|---|---|---|
| Heater substance: 10 (Silicon nitride) | | | | | | |
| Sample | Tubular piece | | | Chamber subst. | Inter-piece separation at normal temperature | |
| | Substance | Fixing means | Length (mm) | | Heater end (L1) | Chamber end (L2) |
| 10-33 | Mullite | Glass | 100 | Stainless steel | 300 | 300 |
| 10-34 | Mullite | Glass | 100 | Stainless steel | 300 | 300 |
| 10-35 | AlN | Glass | 100 | Stainless steel | 300 | 300 |
| 10-36 | AlN | Glass | 150 | Stainless steel | 300 | 300 |
| 10-37 | AlN | Screws | 150 | Stainless steel | 300 | 300 |
| 10-38 | AlN | Screws | 150 | Stainless steel | 299.5 | 300 |
| 10-39 | $Si_3N_4$ | Glass | 150 | Stainless steel | 300 | 300 |
| 10-40 | $Al_2O_3$ | Glass | 150 | Stainless steel | 300 | 300 |
| 10-41 | SiC | Glass | 150 | Stainless steel | 300 | 300 |

Table XXXII   (continued)

| Test conditions Heater substance: 10 (Silicon nitride) | | | | | | |
|---|---|---|---|---|---|---|
| Sample | Tubular piece | | | Chamber subst. | Inter-piece separation at normal temperature | |
| | Substance | Fixing means | Length (mm) | | Heater end (L1) | Chamber end (L2) |
| 10-42 | Ni | Brazing material | 150 | Stainless steel | 300 | 300 |
| 10-43 | W | Brazing material | 150 | Stainless steel | 300 | 300 |
| 10-44 | Mo | Brazing material | 150 | Stainless steel | 300 | 300 |
| 10-45 | Stainless steel | Screws | 150 | Stainless steel | 300 | 300 |

Table XXXIII

| Test results Heater substance: 10 (Silicon nitride) | | | | | | |
|---|---|---|---|---|---|---|
| Sample | Use temp. (°C) | | Inter-piece separation discrepancy when heated | Gastightness | Temp. uniformity (%) | Notes |
| | Heater | Chamber | | | | |
| 10-33 | 500 | 95 | 0.34 mm | Good | ±0.6 | |
| 10-34 | 850 | 153 | 0.61 mm | Good | ±0.6 | |
| 10-35 | 850 | — | | | | O-ring damage |
| 10-36 | 500 | 180 | 0.14 mm | V. good | ±1.0 | |
| 10-37 | 800 | 50 | 0.79 mm | | | Water-cooled; Tubular piece damage |
| 10-38 | 850 | 50 | 0.35 mm | Good | ±1.0 | |
| 10-39 | 850 | 110 | 0.71 mm | | | Tubular piece damage |
| 10-40 | 850 | 123 | 0.68 mm | Good | ±1.0 | |
| 10-41 | 850 | 202 | 0.49 mm | Good | ±1.0 | |
| 10-42 | 850 | | | | | Tubular piece damage when attaching attaching |
| 10-43 | 500 | 171 | 0.16 mm | V. good | ±1.0 | |
| 10-44 | 500 | 171 | 0.16 mm | V. good | ±1.0 | |
| 10-45 | 500 | 107 | 0.32 mm | Good | ±0.8 | |
| 10-33 | 500 | 95 | 0.34 mm | Good | ±0.6 | |
| 10-34 | 850 | 153 | 0.61 mm | Good | ±0.6 | |

Table XXXIV

| Test conditions Heater substance: 10 (Silicon nitride) | | | | | | |
|---|---|---|---|---|---|---|
| Sample | Tubular piece | | | Chamber subst. | Inter-piece separation at normal temperature | |
| | Substance | Fixing means | Length (mm) | | Heater end (L1) | Chamber end (L2) |
| 10-46 | Mullite | Glass | 100 | $Al_2O_3$ | 300 | 300 |
| 10-47 | Mullite | Glass | 100 | $Al_2O_3$ | 300 | 300 |
| 10-48 | AlN | Glass | 100 | $Al_2O_3$ | 300 | 300 |
| 10-49 | AlN | Glass | 150 | $Al_2O_3$ | 300 | 300 |
| 10-50 | AlN | Screws | 150 | $Al_2O_3$ | 300 | 300 |
| 10-51 | AlN | Screws | 150 | $Al_2O_3$ | 299.5 | 300 |
| 10-52 | $Si_3N_4$ | Glass | 150 | $Al_2O_3$ | 300 | 300 |
| 10-53 | $Al_2O_3$ | Glass | 150 | $Al_2O_3$ | 300 | 300 |
| 10-54 | SiC | Glass | 150 | $Al_2O_3$ | 300 | 300 |
| 10-55 | Ni | Brazing material | 150 | $Al_2O_3$ | 300 | 300 |
| 10-56 | W | Brazing material | 150 | $Al_2O_3$ | 300 | 300 |
| 10-57 | Mo | Brazing material | 150 | $Al_2O_3$ | 300 | 300 |
| 10-58 | Stainless steel | Screws | 150 | $Al_2O_3$ | 300 | 300 |

Table XXXV

| Test results Heater substance: 10 (Silicon nitride) | | | | | | |
|---|---|---|---|---|---|---|
| Sample | Use temp. (°C) | | Inter-piece separation discrepancy when heated | Gastightness | Temp. uniformity (%) | Notes |
| | Heater | Chamber | | | | |
| 10-46 | 500 | 99 | 0.34 mm | Good | ±0.6 | |
| 10-47 | 850 | 161 | 0.59 mm | Good | ±0.6 | |
| 10-48 | 850 | — | | | | O-ring damage |
| 10-49 | 500 | 189 | 0.13 mm | V. good | ±1.0 | |
| 10-50 | 800 | 50 | 0.79 mm | | | Water-cooled; Tubular piece damage |
| 10-51 | 850 | 50 | 0.35 mm | Good | ±1.0 | |
| 10-52 | 850 | 113 | 0.70 mm | Good | ±1.0 | |
| 10-53 | 850 | 126 | 0.67 mm | Good | ±1.0 | |
| 10-54 | 850 | 208 | 0.48 mm | Good | ±1.0 | |

Table XXXV   (continued)

| Test results | | | | | | |
| --- | --- | --- | --- | --- | --- | --- |
| Heater substance: 10 (Silicon nitride) | | | | | | |
| Sample | Use temp. (°C) | | Inter-piece separation discrepancy when heated | Gastightness | Temp. uniformity (%) | Notes |
| | Heater | Chamber | | | | |
| 10-55 | 850 | | | | | Tubular piece damage when attaching |
| 10-56 | 500 | 174 | 0.16 mm | V good | ±1.0 | |
| 10-57 | 500 | 175 | 0.16 mm | V. good | ±1.0 | |
| 10-58 | 500 | 110 | 0.31 mm | Good | ±0.8 | |

Table XXXVI

| Test conditions | | | | | | |
| --- | --- | --- | --- | --- | --- | --- |
| Chamber substance: Aluminum | | | | | | |
| Sample | Tubular piece | | | Heater subst. | Inter-piece separation at normal temperature | |
| | Substance | Fixing means | Length (mm) | | Heater end (L1) | Chamber end (L2) |
| Al-1 | Mullite | Glass | 100 | 1 | 300 | 300 |
| Al-2 | Mullite | Screws | 100 | 1 | 300 | 300 |
| Al-3 | Mullite | Glass | 100 | 2 | 300 | 300 |
| Al-4 | Mullite | Screws | 100 | 2 | 300 | 300 |
| Al-5 | Mullite | Glass | 100 | 4 | 300 | 300 |
| Al-6 | Mullite | Screws | 100 | 4 | 300 | 300 |
| Al-7 | Mullite | Glass | 100 | 5 | 300 | 300 |
| Al-8 | Mullite | Screws | 100 | 5 | 300 | 300 |
| Al-9 | Mullite | Glass | 100 | 6 | 300 | 300 |
| Al-10 | Mullite | Screws | 100 | 6 | 300 | 300 |
| Al-11 | Mullite | Glass | 100 | 7 | 300 | 300 |
| Al-12 | Mullite | Screws | 100 | 7 | 300 | 300 |

Table XXXVII

| Test results | | | | | | |
| --- | --- | --- | --- | --- | --- | --- |
| Chamber substance: Aluminum | | | | | | |
| Sample | Use temp. (°C) | | Inter-piece separation discrepancy when heated | Gastightness | Temp. uniformity (%) | Notes |
| | Heater | Chamber | | | | |
| Al-1 | 850 | 150 | 0.11 mm | V. good | ±0.3 | |
| Al-2 | 850 | 145 | 0.15 mm | V. good | ±0.3 | |

Table XXXVII   (continued)

Test results
Chamber substance: Aluminum

| Sample | Use temp. (°C) | | Inter-piece separation discrepancy when heated | Gastightness | Temp. uniformity (%) | Notes |
|---|---|---|---|---|---|---|
| | Heater | Chamber | | | | |
| Al-3 | 850 | 150 | 0.11 mm | V. good | ±0.2 | |
| Al-4 | 850 | 145 | 0.15 mm | V. good | ±0.2 | |
| Al-5 | 850 | 150 | 0.11 mm | V. good | ±0.2 | |
| Al-6 | 850 | 145 | 0.15 mm | V. good | ±0.2 | |
| Al-7 | 850 | 150 | 0.11 mm | V. good | ±0.2 | |
| Al-8 | 850 | 145 | 0.15 mm | V. good | ±0.2 | |
| Al-9 | 850 | 150 | 0.11 mm | V. good | ±0.2 | |
| Al-10 | 850 | 145 | 0.15 mm | V. good | ±0.2 | |
| Al-11 | 850 | 150 | 0.11 mm | V. good | ±0.2 | |
| Al-12 | 850 | 145 | 0.15 mm | V. good | ±0.2 | |

Table XXXVIII

Test conditions
Chamber substance: Nickel

| Sample | Tubular piece | | | Heater subst. | Inter-piece separation at normal temperature | |
|---|---|---|---|---|---|---|
| | Substance | Fixing means | Length (mm) | | Heater end (L1) | Chamber end (L2) |
| Ni-1 | Mullite | Glass | 100 | 1 | 300 | 300 |
| Ni-2 | Mullite | Screws | 100 | 1 | 300 | 300 |
| Ni-3 | Mullite | Glass | 100 | 2 | 300 | 300 |
| Ni-4 | Mullite | Screws | 100 | 2 | 300 | 300 |
| Ni-5 | Mullite | Glass | 100 | 4 | 300 | 300 |
| Ni-6 | Mullite | Screws | 100 | 4 | 300 | 300 |
| Ni-7 | Mullite | Glass | 100 | 5 | 300 | 300 |
| Ni-8 | Mullite | Screws | 100 | 5 | 300 | 300 |
| Ni-9 | Mullite | Glass | 100 | 6 | 300 | 300 |
| Ni-10 | Mullite | Screws | 100 | 6 | 300 | 300 |
| Ni-11 | Mullite | Glass | 100 | 7 | 300 | 300 |
| Ni-12 | Mullite | Screws | 100 | 7 | 300 | 300 |

Table XXXIX

| Test results<br>Chamber substance: Nickel | | | | | | |
|---|---|---|---|---|---|---|
| Sample | Use temp. (°C) | | Inter-piece separation discrepancy when heated | Gastightness | Temp. uniformity (%) | Notes |
| | Heater | Chamber | | | | |
| Ni-1 | 850 | 150 | 0.56 mm | Good | ±0.3 | |
| Ni-2 | 850 | 145 | 0.58 mm | Good | ±0.3 | |
| Ni-3 | 850 | 150 | 0.56 mm | Good | ±0.2 | |
| Ni-4 | 850 | 145 | 0.58 mm | Good | ±0.2 | |
| Ni-5 | 850 | 150 | 0.56 mm | Good | ±0.2 | |
| Ni-6 | 850 | 145 | 0.58 mm | Good | ±0.2 | |
| Ni-7 | 850 | 150 | 0.56 mm | Good | ±0.2 | |
| Ni-8 | 850 | 145 | 0.58 mm | Good | ±0.2 | |
| Ni-9 | 850 | 150 | 0.56 mm | Good | ±0.2 | |
| Ni-10 | 850 | 145 | 0.58 mm | Good | ±0.2 | |
| Ni-11 | 850 | 150 | 0.56 mm | Good | ±0.2 | |
| Ni-12 | 850 | 145 | 0.58 mm | Good | ±0.2 | |

Table XL

| Test conditions<br>Chamber substance: Stainless steel | | | | | | |
|---|---|---|---|---|---|---|
| Sample | Tubular piece | | | Heater subst. | Inter-piece separation at normal temperature | |
| | Substance | Fixing means | Length (mm) | | Heater end (L1) | Chamber end (L2) |
| SUS-1 | Mullite | Glass | 100 | 1 | 300 | 300 |
| SUS-2 | Mullite | Screws | 100 | 1 | 300 | 300 |
| SUS-3 | Mullite | Glass | 100 | 1 | 299.7 | 300 |
| SUS-4 | Mullite | Glass | 100 | 2 | 300 | 300 |
| SUS-5 | Mullite | Screws | 100 | 2 | 300 | 300 |
| SUS-6 | Mullite | Glass | 100 | 2 | 299.7 | 300 |
| SUS-7 | Mullite | Glass | 100 | 4 | 300 | 300 |
| SUS-8 | Mullite | Screws | 100 | 4 | 300 | 300 |
| SUS-9 | Mullite | Glass | 100 | 4 | 299.7 | 300 |
| SUS-10 | Mullite | Glass | 100 | 5 | 300 | 300 |
| SUS-11 | Mullite | Screws | 100 | 5 | 300 | 300 |
| SUS-12 | Mullite | Glass | 100 | 5 | 299.7 | 300 |
| SUS-13 | Mullite | Glass | 100 | 6 | 300 | 300 |
| SUS-14 | Mullite | Screws | 100 | 6 | 300 | 300 |
| SUS-15 | Mullite | Glass | 100 | 6 | 299.7 | 300 |

Table XL   (continued)

| Test conditions Chamber substance: Stainless steel | | | | | | |
|---|---|---|---|---|---|---|
| Sample | Tubular piece | | | Heater subst. | Inter-piece separation at normal temperature | |
| | Substance | Fixing means | Length (mm) | | Heater end (L1) | Chamber end (L2) |
| SUS-16 | Mullite | Glass | 100 | 7 | 300 | 300 |
| SUS-17 | Mullite | Screws | 100 | 7 | 300 | 300 |
| SUS-18 | Mullite | Glass | 100 | 7 | 299.7 | 300 |
| SUS-19 | Mullite | Glass | 100 | 1 | 300 | 300 |
| SUS-20 | Mullite | Screws | 100 | 1 | 300 | 300 |
| SUS-21 | Mullite | Glass | 100 | 2 | 300 | 300 |
| SUS-22 | Mullite | Screws | 100 | 2 | 300 | 300 |
| SUS-23 | Mullite | Glass | 100 | 4 | 300 | 300 |
| SUS-24 | Mullite | Screws | 100 | 4 | 300 | 300 |
| SUS-25 | Mullite | Glass | 100 | 5 | 300 | 300 |
| SUS-26 | Mullite | Screws | 100 | 5 | 300 | 300 |
| SUS-27 | Mullite | Glass | 100 | 6 | 300 | 300 |
| SUS-28 | Mullite | Screws | 100 | 6 | 300 | 300 |
| SUS-29 | Mullite | Glass | 100 | 7 | 300 | 300 |
| SUS-30 | Mullite | Screws | 100 | 7 | 300 | 300 |

Table XLI

| Test results Chamber substance: Stainless steel | | | | | | |
|---|---|---|---|---|---|---|
| Sample | Use temp. (°C) | | Inter-piece separation discrepancy when heated | Gastightness | Temp. uniformity (%) | Notes |
| | Heater | Chamber | | | | |
| SUS-1 | 850 | 150 | 0.79 mm | | | Tubular piece damage |
| SUS-2 | 850 | 145 | 0.80 mm | | | Tubular piece damage |
| SUS-3 | 850 | 150 | 0.49 mm | Good | ±0.2 | |
| SUS-4 | 850 | 150 | 0.79 mm | | | Tubular piece damage |
| SUS-5 | 850 | 145 | 0.80 mm | | | Tubular piece damage |
| SUS-6 | 850 | 150 | 0.49 mm | Good | ±0.2 | |
| SUS-7 | 850 | 150 | 0.79 mm | | | Tubular piece damage |

Table XLI   (continued)

| Test results | | | | | | |
|---|---|---|---|---|---|---|
| Chamber substance: Stainless steel | | | | | | |
| Sample | Use temp. (°C) | | Inter-piece separation discrepancy when heated | Gastightness | Temp. uniformity (%) | Notes |
| | Heater | Chamber | | | | |
| SUS-8 | 850 | 145 | 0.80 mm | | | Tubular piece damage |
| SUS-9 | 850 | 150 | 0.49 mm | Good | ±0.2 | |
| SUS-10 | 850 | 150 | 0.79 mm | | | Tubular piece damage |
| SUS-11 | 850 | 145 | 0.80 mm | | | Tubular piece damage |
| SUS-12 | 850 | 150 | 0.49 mm | Good | ±0.2 | |
| SUS-13 | 850 | 150 | 0.79 mm | | | Tubular piece damage |
| SUS-14 | 850 | 145 | 0.80 mm | | | Tubular piece damage |
| SUS-15 | 850 | 150 | 0.49 mm | Good | ±0.2 | |
| SUS-16 | 850 | 150 | 0.79 mm | | | Tubular piece damage |
| SUS-17 | 850 | 145 | 0.80 mm | | | Tubular piece damage |
| SUS-18 | 850 | 150 | 0.49 mm | Good | ±0.2 | |
| SUS-19 | 500 | 95 | 0.45 mm | Good | ±0.2 | |
| SUS-20 | 500 | 93 | 0.45 mm | Good | ±0.2 | |
| SUS-21 | 500 | 95 | 0.45 mm | Good | ±0.2 | |
| SUS-22 | 500 | 93 | 0.45 mm | Good | ±0.2 | |
| SUS-23 | 500 | 95 | 0.45 mm | Good | ±0.2 | |
| SUS-24 | 500 | 93 | 0.45 mm | Good | ±0.2 | |
| SUS-25 | 500 | 95 | 0.45 mm | Good | ±0.2 | |
| SUS-26 | 500 | 93 | 0.45 mm | Good | ±0.2 | |
| SUS-27 | 500 | 95 | 0.45 mm | Good | ±0.2 | |
| SUS-28 | 500 | 93 | 0.45 mm | Good | ±0.2 | |
| SUS-29 | 500 | 95 | 0.45 mm | Good | ±0.2 | |
| SUS-30 | 500 | 93 | 0.45 mm | Good | ±0.2 | |

Table XLII

| Test conditions Chamber substance: Alumina | | | | | | |
|---|---|---|---|---|---|---|
| Sample | Tubular piece | | | Heater subst. | Inter-piece separation at normal temperature | |
| | Substance | Fixing means | Length (mm) | | Heater end (L1) | Chamber end (L2) |
| $Al_2O_3$-1 | Mullite | Glass | 100 | 1 | 300 | 300 |
| $Al_2O_3$-2 | Mullite | Screws | 100 | 1 | 300 | 300 |
| $Al_2O_3$-3 | Mullite | Glass | 100 | 2 | 300 | 300 |
| $Al_2O_3$-4 | Mullite | Screws | 100 | 2 | 300 | 300 |
| $Al_2O_3$-5 | Mullite | Glass | 100 | 4 | 300 | 300 |
| $Al_2O_3$-6 | Mullite | Screws | 100 | 4 | 300 | 300 |
| $Al_2O_3$-7 | Mullite | Glass | 100 | 5 | 300 | 300 |
| $Al_2O_3$-8 | Mullite | Screws | 100 | 5 | 300 | 300 |
| $Al_2O_3$-9 | Mullite | Glass | 100 | 6 | 300 | 300 |
| $Al_2O_3$-10 | Mullite | Screws | 100 | 6 | 300 | 300 |
| $Al_2O_3$-11 | Mullite | Glass | 100 | 7 | 300 | 300 |
| $Al_2O_3$-12 | Mullite | Screws | 100 | 7 | 300 | 300 |

Table XLIII

| Test results Chamber substance: Alumina | | | | | | |
|---|---|---|---|---|---|---|
| Sample | Use temp. (°C) | | Inter-piece separation discrepancy when heated | Gastightness | Temp. uniformity (%) | Notes |
| | Heater | Chamber | | | | |
| $Al_2O_3$-1 | 500 | 96 | 0.45 mm | Good | ±0.2 | |
| $Al_2O_3$-2 | 500 | 94 | 0.46 mm | Good | ±0.2 | |
| $Al_2O_3$-3 | 500 | 96 | 0.45 mm | Good | ±0.2 | |
| $Al_2O_3$-4 | 500 | 94 | 0.46 mm | Good | ±0.2 | |
| $Al_2O_3$-5 | 500 | 96 | 0.45 mm | Good | ±0.2 | |
| $Al_2O_3$-6 | 500 | 94 | 0.46 mm | Good | ±0.2 | |
| $Al_2O_3$-7 | 500 | 96 | 0.45 mm | Good | ±0.2 | |
| $Al_2O_3$-8 | 500 | 94 | 0.46 mm | Good | ±0.2 | |
| $Al_2O_3$-9 | 500 | 96 | 0.45 mm | Good | ±0.2 | |
| $Al_2O_3$-10 | 500 | 94 | 0.46 mm | Good | ±0.2 | |
| $Al_2O_3$-11 | 500 | 96 | 0.45 mm | Good | ±0.2 | |
| $Al_2O_3$-12 | 500 | 94 | 0.46 mm | Good | ±0.2 | |

Table XLIV

| Test conditions<br>Heater substance: 3 (Aluminum nitride) | | | | | | |
|---|---|---|---|---|---|---|
| Sample | Columnar piece | | | Chamber subst. | Dist. btwn. columnar pieces at normal temp. (mm) | |
| | Substance | Affixing means | Length (mm) | | Heater end (L1) | Chamber end (L2) |
| 3-80 | Mullite | Glass | 100 | Al | 300 | 300 |
| 3-81 | Mullite | Glass | 100 | Al | 300 | 300 |
| 3-82 | Mullite | Screws | 100 | Al | 300 | 300 |
| 3-83 | Mullite | Snugging | 100 | Al | 300 | 300 |
| 3-84 | AlN | Glass | 100 | Al | 300 | 300 |
| 3-85 | AlN | Snugging | 150 | Al | 300 | 300 |
| 3-86 | AlN | Glass | 150 | Al | 300 | 300 |
| 3-87 | AlN | Screws | 150 | Al | 300 | 300 |
| 3-88 | AlN | Screws | 150 | Al | 299.5 | 300 |
| 3-89 | AlN | Screws | 150 | Al | 300 | 300.5 |
| 3-90 | AlN | Unitary type | 150 | Al | 300 | 300.5 |
| 3-91 | $Si_3N_4$ | Glass | 150 | Al | 300 | 300 |
| 3-92 | $Al_2O_3$ | Glass | 150 | Al | 300 | 300 |
| 3-93 | $Al_2O_3$ | Snugging | 150 | Al | 300 | 300 |
| 3-94 | SiC | Glass | 150 | Al | 300 | 300 |
| 3-95 | Ni | Brazing material | 150 | Al | 300 | 300 |
| 3-96 | W | Brazing material | 150 | Al | 300 | 300 |
| 3-97 | W | Snugging | 150 | Al | 300 | 300 |
| 3-98 | Mo | Brazing material | 150 | Al | 300 | 300 |
| 3-99 | Stainless steel | Screws | 150 | Al | 300 | 300 |

Table XLV

| Test results<br>Heater substance: 3 (Aluminum nitride) | | | | | | |
|---|---|---|---|---|---|---|
| Sample | Use temp. (°C) | | Dist. differential btwn. columnar pieces when heated | Gastightness | Temp. uniformity (%) | Notes |
| | Heater | Chamber | | | | |
| 3-80 | 500 | 95 | 0.02 mm | V good | ±0.2 | Excellent |
| 3-81 | 850 | 150 | 0.11 mm | V good | ±0.2 | |
| 3-82 | 850 | 145 | 0.15 mm | V good | ±0.2 | |

Table XLV (continued)

| Test results | | | | | | |
| --- | --- | --- | --- | --- | --- | --- |
| Heater substance: 3 (Aluminum nitride) | | | | | | |
| Sample | Use temp. (°C) | | Dist. differential btwn. columnar pieces when heated | Gastightness | Temp. uniformity (%) | Notes |
| | Heater | Chamber | | | | |
| 3-83 | 850 | 145 | 0.15 mm | V good | ±0.2 | |
| 3-84 | 850 | — | | | | O-ring destroyed |
| 3-85 | 800 | 50 | 0.73 mm | Good | ±0.4 | Water-cooled |
| 3-86 | 500 | 180 | 0.57 mm | Good | ±0.4 | |
| 3-87 | 800 | 50 | 0.73 mm | | | Water-cooled, Columnar piece destroyed |
| 3-88 | 850 | 50 | 0.30 mm | V good | ±0.4 | |
| 3-89 | 850 | 50 | 0.30 mm | V good | ±0.4 | |
| 3-90 | 850 | 50 | 0.30 mm | V good | ±0.4 | |
| 3-91 | 850 | 110 | 0.39 mm | Good | ±0.3 | |
| 3-92 | 850 | 120 | 0.32 mm | Good | ±0.3 | |
| 3-93 | 850 | 118 | 0.33 mm | Good | ±0.3 | |
| 3-94 | 850 | 200 | 0.23 mm | V. good | ±0.4 | |
| 3-95 | 850 | — | | | | Columnar piece damage when attaching |
| 3-96 | 500 | 170 | 0.50 mm | Good | ±0.4 | |
| 3-97 | 500 | 167 | 0.48 mm | Good | ±0.4 | |
| 3-98 | 500 | 170 | 0.50 mm | Good | ±0.4 | |
| 3-99 | 500 | 105 | 0.05 mm | V good | ±0.3 | |

*Embodiment Two*

The Sample 3-1 wafer holder employed in Embodiment 1 was readied. To this a reflection plate made of stainless steel was attached, and with the temperature of the ceramic susceptor raised to 500°C the susceptor power consumption was measured. Holes 12 mm in diameter were drilled in the reflection plate so as to allow the tubular pieces and/or support pieces to pass through. Power-consumption measurements were also made at different installment separations between the reflection plate and the ceramic susceptor. The stainless steel plate therein was of 0.5 mm thickness, 330 mm diameter, and Ra = 0.05 μm microroughness. The results are set forth in the following Table XLVI.

Table XLVI

| Heater-to-reflection plate separation (mm) | Power consumption (W) |
| --- | --- |
| None | 1200 |
| 15 | 850 |
| 30 | 900 |
| 50 | 1050 |

Table XLVI   (continued)

| Heater-to-reflection plate separation (mm) | Power consumption (W) |
| --- | --- |
| 70 | 1150 |
| 90 | 1200 |

In addition, power consumption was likewise measured with the position of the reflection plate being fixed at 15 mm from the ceramic susceptor, and with the microroughness of the reflection plate being varied. The results obtained are set forth in Table XLVII. From these results it will be understood that the power consumption may be reduced by employing a reflection plate whose microroughness is 1.0 μm or less (Ra), furthermore 0.1 μm or less, installed in a position near the ceramic susceptor.

Table XLVII

| Reflection plate roughness [Ra] (μm) | Power consumption (W) |
| --- | --- |
| 0.05 | 850 |
| 0.10 | 900 |
| 0.5 | 950 |
| 1.0 | 1050 |
| 3.0 | 1200 |

*Embodiment Three*

One end of tubular pieces and support pieces made of mullite, similar to those of Embodiment 1, were by glass bonding attached to the aluminum nitride susceptor employed in Embodiment 1. In doing so, the parallelism was varied by polishing the tubular-piece and support-piece end faces for the susceptor bonding face to change the angle of their attachment to the susceptor. The other ends of the tubular pieces and support pieces were then mounted into a reaction chamber made of aluminum, and the reaction chamber interior was pumped down to assay its helium leak rate. The results are set forth in Table XLVIII. Here, the microroughness in the vicinity of the O-ring abutment area on the mullite tubular pieces and support pieces was Ra $\leq$ 0.3 μm in every case, and as a result of observing the surface under an optical microscope, that there were no defects exceeding 0.05 mm was verified.

Table XLVIII

| Tubular-piece/support-piece parallelism (mm) | Helium leak rate (Pam$^3$/s) |
| --- | --- |
| 1.5 | Damaged fitting into chamber |
| 1.0 | $1.0 \times 10^{-7}$ |
| 0.5 | $7.0 \times 10^{-9}$ |
| 0.3 | $1.0 \times 10^{-9}$ |

*Embodiment Four*

Next the microroughness in the vicinity of the O-ring abutment area of a plurality of mullite tubular pieces in being fitted into the reaction chamber was varied, and they were attached, by glass bonding, to the ceramic susceptor using the same technique as in Embodiment 1. After mounting the tubular pieces into the reaction chamber, the reaction chamber interior was pumped down to assay the helium leak rate of the seal areas. The results are set forth in Table XLIX.

Table XLIX

| Roughness [Ra] (μm) | Vacuum grease application | Helium leak rate (Pam$^3$/s) |
| --- | --- | --- |
| 6.0 | Present | Not measurable |
| 5.0 | Present | $1.0 \times 10^{-7}$ |

Table XLIX   (continued)

| Roughness [Ra] (µm) | Vacuum grease application | Helium leak rate (Pam$^3$/s) |
| --- | --- | --- |
| 5.0 | Absent | Not measurable |
| 3.0 | Present | 2.5 x 10$^{-8}$ |
| 1.0 | Present | 1.0 x 10$^{-9}$ |
| 1.0 | Absent | 1.0 x 10$^{-7}$ |
| 0.5 | Absent | 5.0 x 10$^{-9}$ |
| 0.3 | Absent | 1.0 x 10$^{-9}$ |
| 0.2 | Absent | 0.7 x 10$^{-9}$ |

*Embodiment Five*

The same tubular pieces made of mullite as in Embodiment 1 were readied for the aluminum nitride susceptor employed in Embodiment 1. From among them, mullite tubular pieces on which there were defects differing in size in the vicinity of the O-ring abutment area were selected out; these as well as tubular pieces having no defects were respectively glass-bonded to an aluminum nitride susceptor. Subsequently the remaining ends of the tubular pieces were mounted into the reaction chamber, and after pumping the chamber down, the helium leak rate where the O-rings abut on the face of the tubular pieces was assayed. The results are set forth in Table L.

Table L

| Defect dia. (mm) | Vacuum grease application | Helium leak rate (Pam$^3$/s) |
| --- | --- | --- |
| 1.3 | Present | Not measurable |
| 1.0 | Present | 1.0 x 10$^{-7}$ |
| 1.0 | Absent | Not measurable |
| 0.5 | Present | 2.0 x 10$^{-8}$ |
| 0.3 | Absent | 1.0 x 10$^{-7}$ |
| 0.05 | Absent | 1.0 x 10$^{-9}$ |
| None | Absent | 5.0 x 10$^{-9}$ |

*Embodiment Six*

Tubular pieces and support pieces made of mullite, similar to those of Embodiment 1, were by glass bonding attached to the aluminum nitride susceptor employed in Embodiment 1. In doing so, the parallelism of the ceramic susceptor and reaction chamber was varied by polishing the tubular-piece and support-piece end faces for the susceptor bonding face to change the angle of their attachment to the susceptor. These ceramic susceptors were installed in a reaction chamber made of aluminum, the reaction chamber interior was pumped down, and a wafer mounting/demounting test was carried out. The results are set forth in Table LI.

Table LI

| Heater/chamber parallelism (mm) | Wafer loading result |
| --- | --- |
| 1.5 | Drop-off when loading |
| 1.0 | No drop-off; wafer edge ride-up on pocket rim |
| 0.5 | No drop-off; wafer edge ride-up on pocket rim |
| 0.2 | Neither drop-off nor ride-up |
| 0.1 | Neither drop-off nor ride-up |

*Embodiment Seven*

The anti-corrosive properties of the ceramic susceptors were compared, and in order to do so, the top face of each of the sintered ceramic compacts set forth in the foregoing Table I was polished. After being processed each of the sintered-compact samples was checked for usability by the following protocol.

At first a discoid heater was fashioned with a specially prepared aluminum-nitride ceramic as a matrix, into which a tungsten filament was embedded. Next, each of the sintered-compact samples in Table I was set on the susceptor, which was then arranged within the vacuum chamber of a plasma-generating apparatus using 13.56 MHz high RF power. The sintered-compact samples were each treated 5 hours at a 100°C heating temperature under a $CF_4$ gas environment having a plasma density of 1.4 W/cm². After that the density of etch pits on the plasma-irradiated face was examined (number of pits whose maximum diametric span is at least 1 μm, present within a arbitrary surface visual field of 1000 μm² when observed using a scanning electron micrograph); the counts are set forth in Table LII below.

Table LII

| Sample | Susceptor chief component | Sintering additive (add. amt.) | Pit count |
|--------|--------------------------|-------------------------------|-----------|
| 1 | Aluminum nitride | — | 18 |
| 2 | Aluminum nitride | $Y_2O_3$ (0.05%) | 9 |
| 3 | Aluminum nitride | $Y_2O_3$ (0.5%) | 4 |
| 4 | Aluminum nitride | $Y_2O_3$ (1.0%) | 6 |
| 5 | Aluminum nitride | $Y_2O_3$ (5.0%) | 17 |
| 6 | Aluminum nitride | $Eu_2O_3$ (0.5%) | 11 |
| 7 | Aluminum nitride | $Nd_2O_3$ (0.5%) | 10 |
| 8 | Silicon carbide | — | 22 |
| 9 | Alumina | MgO (0.5%) | 25 |
| 10 | Silicon nitride | $Y_2O_3$ (0.5%) | 32 |
| 11 | Aluminum nitride | $Y_2O_3$ (3.0%) | 13 |

It will be understood from the results noted above that aluminum nitride is superior in terms of anti-corrosiveness, and that the samples thereof where the amount of sintering additive was from 0.05 weight % to 1.0 weight % were especially favorable.

*Embodiment Eight*

The wafer holders from Embodiment 1 that yielded excellent results were each introduced into a semiconductor manufacturing apparatus, and were run respectively in plasma-assisted CVD, low-pressure CVD, low-*k* film baking, plasma etching, and dielectric-film CVD operations. The result was that there were no incidents of damage to either the anchored tubular pieces and/or anchored support pieces with any of the holders while wafers were being processed. In the low-*k* film baking application in particular, especially homogeneous film quality was obtained.

*Embodiment Nine*

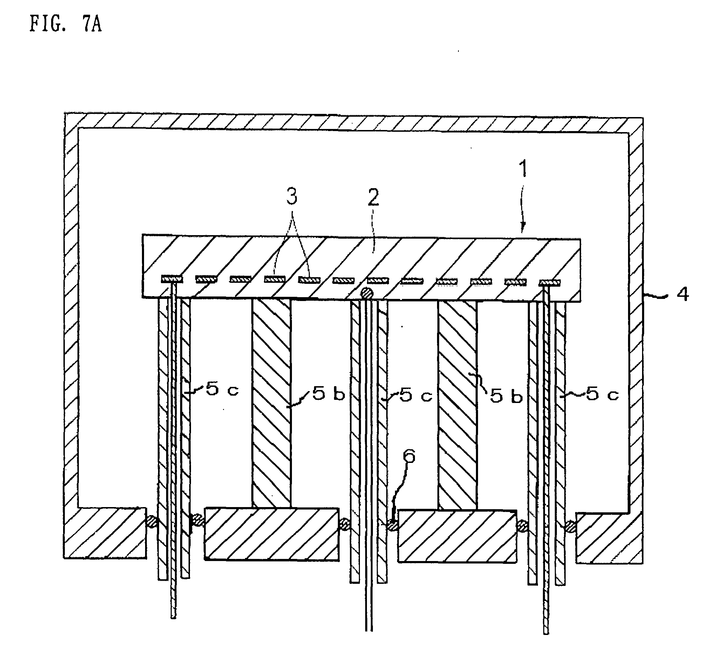

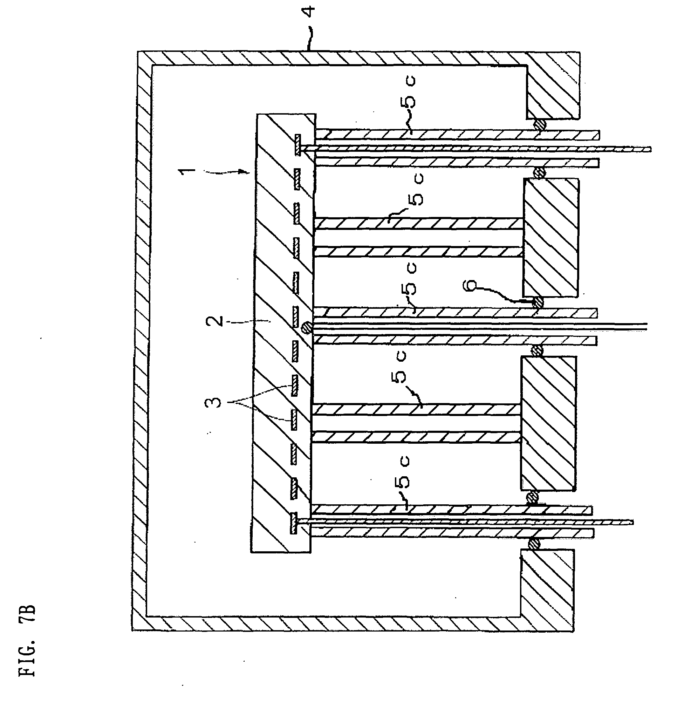

Next various example structures will be discussed. These structures may variously be selected in accordance with each application, reaction-chamber configuration, etc. For example, as illustrated in Fig. 7A, support pieces 5b are set up in the vicinity of the center of the reaction chamber 4. If in this instance the support pieces 5b are not anchored to the reaction chamber 4, then either joining or not joining the support pieces 5b to the ceramic susceptor 2 is fine. By the same token, conversely a structure may be adopted in which the support pieces 5b are anchored into the reaction chamber 4 by a technique such as brazing, but are not anchored along the susceptor 2 end. In addition, as illustrated in Figs. 7A and 7B, a plurality of tubular pieces 5c and support pieces 5b can be set up, and the susceptor can be supported by them. If in this case the tubular pieces 5c and support pieces 5b are not anchored to the reaction chamber 4, then either joining or not joining the tubular pieces 5c and support pieces 5b to the ceramic susceptor 2 is fine. By the same token, conversely a structure may be adopted in which the tubular pieces 5c and support pieces 5b are anchored into the reaction chamber 4 by a technique such as brazing, but are not anchored with the susceptor 2 side. Here, in an instance of a structure of this sort in which the tubular pieces 5c and support pieces 5b are not affixed to the ceramic susceptor, the tubular pieces 5c and support pieces 5b need not satisfy the relational formulas according to the present invention can be installed in unlimited positions.

Industrial Applicability

The present invention eliminates damage to the tubular pieces serving to house electrode terminals and leads for supplying power to a ceramic susceptor and to house temperature-measuring probes, as well as damage to support parts that support the ceramic susceptor-even with the housing/supporting components being anchored to the susceptor and its reaction chamber-thereby affording wafer holders realizing very significant improvement in reliability, and semiconductor manufacturing apparatuses in which the wafer holders are employed.

**Claims**

1. A wafer holder for retaining and processing a semiconductor wafer on the holder's ceramic susceptor supported within a reaction chamber by tubular pieces, at least two of the tubular pieces being anchored tubular pieces in which one end is affixed onto the ceramic susceptor and the other end is fixed into the reaction chamber, **characterized in that** letting

the highest temperature said ceramic susceptor attains be $T1$,
the thermal expansion coefficient of said ceramic susceptor be $\alpha1$,
the highest temperature said reaction chamber attains be $T2$,
the thermal expansion coefficient of said reaction chamber be $\alpha2$,
the longest separation on said ceramic susceptor between said anchored tubular pieces at normal temperature be $L1$, and
the longest separation on said reaction chamber between said anchored tubular pieces at normal temperature be $L2$,
then the wafer holder satisfies the following relational formula:

$$|(T1{\times}\alpha1{\times}L1) - (T2{\times}\alpha2{\times}L2)| \leq 0.7 \text{ mm.}$$

2. A wafer holder for retaining and processing a semiconductor wafer on the holder's ceramic susceptor supported within a reaction chamber by tubular pieces and/or support pieces, wherein at least two of said tubular pieces and/or said support pieces are anchored tubular pieces and/or support pieces in which one end is affixed onto the ceramic susceptor and the other end is fixed into the reaction chamber, **characterized in that** letting

the highest temperature said ceramic susceptor attains be $T1$,
the thermal expansion coefficient of said ceramic susceptor be $\alpha1$,
the highest temperature said reaction chamber attains be $T2$,
the thermal expansion coefficient of said reaction chamber be $\alpha2$,
the longest separation on said ceramic susceptor between said anchored tubular pieces and/or said anchored support pieces at normal temperature be $L1$, and
the longest separation on said reaction chamber between said anchored tubular pieces and/or said anchored support pieces at normal temperature be $L2$,
then the wafer holder satisfies the relational formula:

$$|(T1{\times}\alpha1{\times}L1) - (T2{\times}\alpha2{\times}L2)| \leq 0.7 \text{ mm.}$$

3. A wafer holder as set forth in claim 1 or 2, **characterized in that** said relational formula is:

$$|(T1{\times}\alpha1{\times}L1) - (T2{\times}\alpha2{\times}L2)| \leq 0.3 \text{ mm.}$$

4. A wafer holder as set forth in any of claims 1-3, **characterized in that** the thermal expansion coefficient of said ceramic susceptor is $8.0 \times 10^{-6}$/K or less, and **in that** the thermal expansion coefficient of said reaction chamber is $15 \times 10^{-6}$/K or more.

**5.** A wafer holder as set forth in claim 5, **characterized in that** the thermal expansion coefficient of said ceramic susceptor is $6.0 \times 10^{-6}$/K or less, and **in that** the thermal expansion coefficient of said reaction chamber is $20 \times 10^{-6}$/K or more.

**6.** A wafer holder as set forth in any of claims 1-5, **characterized in that** the length of said anchored tubular pieces and/or said anchored support pieces from said ceramic susceptor to said reaction chamber is 320 mm or less.

**7.** A wafer holder as set forth in any of claims 1-4, **characterized in that** the length of said anchored tubular pieces and/or said anchored support pieces from said ceramic susceptor to said reaction chamber is 150 mm or less, and the thermal conductivity of said anchored tubular pieces and/or said anchored support pieces is 30 W/mK or less.

**8.** A wafer holder as set forth in any of claims 1-5, **characterized in that** said reaction chamber is not water-cooled.

**9.** A wafer holder as set forth in any of claims 1-8, **characterized in that** a reflection plate for reflecting heat from said ceramic susceptor is furnished in between said reaction chamber and said ceramic susceptor.

**10.** A wafer holder as set forth in any of claims 1-9, **characterized in that** the parallelism of each of said anchored tubular pieces and/or said anchored support pieces, the respective ends of which being anchored along said reaction chamber and along said ceramic susceptor, is within 1.0 mm.

**11.** A wafer holder as set forth claim 10, **characterized in that** the parallelism of each of said anchored tubular pieces and/or said anchored support pieces is within 0.3 mm.

**12.** A wafer holder as set forth in any of claims 1-9, **characterized in that** an O-ring fixed in said reaction chamber and being for maintaining gastightness against the reaction chamber exterior is provided, wherein the microroughness in the vicinity of where the face of said tubular pieces and/or said support pieces abuts on said O-ring is 5.0 μm or less (Ra).

**13.** A wafer holder as set forth claim 12, **characterized in that** the microroughness in the vicinity of where the face of said tubular pieces and/or said support pieces abuts on said O-ring is 1.0 μm or less (Ra).

**14.** A wafer holder as set forth claim 13, **characterized in that** the microroughness in the vicinity of where the face of said tubular pieces and/or said support pieces abuts on the O-ring is 0.3 μm or less (Ra).

**15.** A wafer holder as set forth in any of claims 1-14, **characterized in that** an O-ring fixed in said reaction chamber and being for maintaining gastightness against the reaction chamber exterior is provided, wherein the size of surface defects present in the vicinity of where the face of said tubular pieces and/or said support pieces abuts on said O-ring is 1 mm or less in diameter.

**16.** A wafer holder as set forth claim 15, **characterized in that** the size of surface defects present in the vicinity of where the face of said tubular pieces and/or said support pieces abuts on said O-ring is 0.3 mm or less in diameter.

**17.** A wafer holder as set forth claim 16, **characterized in that** the size of surface defects present in the vicinity of where the face of said tubular pieces and/or said support pieces abuts on said O-ring is 0.3 mm or less in diameter.

**18.** A wafer holder as set forth in any of claims 1-17, **characterized in that** the thickness uniformity of said ceramic susceptor and the bottom part of said reaction chamber is within 1.0 mm.

**19.** A wafer holder as set forth in claim 18, **characterized in that** the thickness uniformity of said ceramic susceptor and the bottom part of said reaction chamber is within 0.2 mm.

**20.** A wafer holder as set forth in any of claims 1-19, **characterized in that** the principal component of said ceramic susceptor is one of alumina, silicon nitride, aluminum nitride or silicon carbide.

**21.** A wafer holder as set forth in any of claims 1-20, **characterized in that** the principal component of said ceramic susceptor is aluminum nitride, the principal component of said reaction chamber is either aluminum or an aluminum alloy, and the principal component of said anchored tubular pieces and/or said anchored support pieces is either mullite or a mullite-alumina composite.

**22.** A semiconductor manufacturing apparatus **characterized in** being equipped with a wafer holder as set forth in any of claims 1-21.

**23.** A semiconductor manufacturing apparatus as set forth in claim 22, **characterized in** being employed in low-*k* film baking.

EP 1 544 898 A1

FIG. 1B

FIG. 2A

FIG. 2B

FIG. 3A

FIG.3B

FIG. 4A

FIG. 4B

FIG. 5A

FIG. 5B

FIG. 6A

FIG. 6B

FIG. 7A

FIG. 7B

| INTERNATIONAL SEARCH REPORT | International application No.<br>PCT/JP03/12311 |
|---|---|

**A. CLASSIFICATION OF SUBJECT MATTER**
Int.Cl⁷ H01L21/02, H01L21/31, H01L21/68, C23C16/44, H05B3/02

According to International Patent Classification (IPC) or to both national classification and IPC

**B. FIELDS SEARCHED**

Minimum documentation searched (classification system followed by classification symbols)
Int.Cl⁷ H01L21/02, H01L21/31, H01L21/68, C23C16/44, H05B3/02

Documentation searched other than minimum documentation to the extent that such documents are included in the fields searched

| | | | |
|---|---|---|---|
| Jitsuyo Shinan Koho | 1922–1996 | Jitsuyo Shinan Toroku Koho | 1996–2004 |
| Kokai Jitsuyo Shinan Koho | 1971–2004 | Toroku Jitsuyo Shinan Koho | 1994–2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | EP 1126547 A1 (APPLIED MATERIALS, INC.),<br>22 August, 2001 (22.08.01),<br>Full text; Figs. 1 to 3<br>& JP 2000-133339 A<br>Full text; Figs. 1 to 3<br>& WO 00/26995 A1 | 1-23 |
| A | US 5753891 A (TOKYO ELECTRON LTD.),<br>19 May, 1998 (19.05.98),<br>Full text; Figs. 1 to 16<br>& JP 8-218172 A<br>Full text; Figs. 1 to 7 | 1-23 |
| A | JP 2000-344584 A (NGK Insulators, Ltd.),<br>12 December, 2000 (12.12.00),<br>Full text; Figs. 1 to 10<br>(Family: none) | 1-23 |

☐ Further documents are listed in the continuation of Box C.    ☐ See patent family annex.

| | |
|---|---|
| *   Special categories of cited documents:<br>"A" document defining the general state of the art which is not considered to be of particular relevance<br>"E" earlier document but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>08 January, 2004 (08.01.04) | Date of mailing of the international search report<br>27 January, 2004 (27.01.04) |
|---|---|
| Name and mailing address of the ISA/<br>   Japanese Patent Office | Authorized officer |
| Facsimile No. | Telephone No. |

Form PCT/ISA/210 (second sheet) (July 1998)